# EUROPÄISCHE PATENTSCHRIFT

(11) **EP 4 516 075 B1**
(45) Veröffentlichungstag und Bekanntmachung des Hinweises auf die Patenterteilung: **04.02.2026**
(21) Anmeldenummer: 23729979.7
(22) Anmeldetag: 24.05.2023
(51) Int. Cl.: H05K 5/06, H05K 7/14

(54) **AUTOMATISIERUNGSPLATTFORM**
AUTOMATION PLATFORM
PLATE-FORME D'AUTOMATISATION

(30) Priorität: 25.05.2022 DE 102022113306
(43) Veröffentlichungstag der Anmeldung: 05.03.2025
(73) Patentinhaber: Beckhoff Automation GmbH, 33415 Verl (DE)
(72) Erfinder: MELZER, Udo, 33335 Gütersloh (DE); SIEGENBRINK, Daniel, 33617 Bielefeld (DE)
(74) Vertreter: Patentanwaltskanzlei WILHELM & BECK
(86) Internationale Anmeldenummer: PCT/EP2023/063919
(87) Internationale Veröffentlichungsnummer: WO 2023/227665

(56) Entgegenhaltungen:
- EP-A2- 1 587 352
- DE-A1- 102019 106 082

## Beschreibung

Die vorliegende Erfindung betrifft ein Funktionsmodul für eine Automatisierungsplattform, eine Automatisierungsplattform und ein Verfahren zum Montieren einer Automatisierungsplattform.

Diese Patentanmeldung beansprucht die Priorität der deutschen Patentanmeldung DE 10 2022 113 306.0 vom 25. Mai 2022.

Modulare Automatisierungsplattformen mit einem Basismodul und einer Mehrzahl von Funktionsmodulen sind aus dem Stand der Technik bekannt. Um eine Automatisierungsplattform vor Feuchtigkeit und/oder Staub zu schützen, werden Dichtungen zwischen den Funktionsmodulen und dem Basismodul verwendet.

Aus der DE 10 2019 106082 A1 ist eine Automatisierungsplattform mit den Merkmalen des ersten Teils des Anspruch 1 und ein Funktionsmodul für eine Automatisierungsplattform mit den Merkmalen des ersten Teils des Anspruch 9 bekannt. Die EP 1 587 352 A2 offenbart eine Baugruppe mit zwei Teilkomponenten und einem Dichtungsmodul, das zwischen die zwei Teilkomponenten einsetzbar ist.

Eine Aufgabe der vorliegenden Erfindung besteht darin, eine verbesserte Automatisierungsplattform und ein verbessertes Funktionsmodul für eine Automatisierungsplattform bereitzustellen sowie ein verbessertes Verfahren zum Montieren einer Automatisierungsplattform anzugeben.

Diese Aufgaben werden durch ein Funktionsmodul für eine Automatisierungsplattform, eine Automatisierungsplattform und ein Verfahren zum Montieren einer Automatisierungsplattform mit den Merkmalen der jeweils unabhängigen Ansprüche gelöst. Vorteilhafte Weiterbildungen sind in abhängigen Ansprüchen angegeben.

Eine Automatisierungsplattform weist ein Basismodul, zumindest ein Funktionsmodul und zumindest eine Verbindungseinrichtung zum Verbinden von Basismodul und Funktionsmodul auf. Das Basismodul weist ein Basisgehäuse mit einer Basisgehäuse-Anschlussfläche auf. Die Basisgehäuse-Anschlussfläche weist zumindest eine erste Öffnung auf. In der Basisgehäuse-Anschlussfläche ist ein um die erste Öffnung umlaufender Vorsprung ausgebildet. Das Funktionsmodul weist ein Funktionsgehäuse mit einer Funktionsgehäuse-Anschlussfläche auf. Die Funktionsgehäuse-Anschlussfläche weist zumindest eine zweite Öffnung, zumindest ein an der zweiten Öffnung angeordnetes Eingriffselement und einen um die zweite Öffnung umlaufenden Dichtungsstutzen auf. Eine Wandung des Eingriffselements weist eine Aussparung auf. Eine die Aussparung begrenzende Kante der Wandung des Eingriffselements bildet auf einer von der Funktionsgehäuse-Anschlussfläche abgewandten Seite der Aussparung einen Anschlag. Das Funktionsmodul weist eine Kappenstruktur mit einer Hartkomponente und einer an der Hartkomponente angeordnete Weichkomponente auf. Die Hartkomponente weist einen um die zweite Öffnung umlaufenden Rahmen und zumindest eine mit dem Rahmen verbundene Steckaufnahme auf. Die Weichkomponente der Kappenstruktur ist an einer der Funktionsgehäuse-Anschlussfläche zugewandten Seite des Rahmens angeordnet und umläuft die zweite Öffnung lateral. An einer Wandung der Steckaufnahme ist ein Rasthaken angeordnet. Das Eingriffselement ist derart in die Steckaufnahme eingeschoben, dass die Weichkomponente an einer Außenwandung des Dichtungsstutzens anliegt und der Rasthaken in die Aussparung eingreift. Wenn das Funktionsmodul auf dem Basismodul aufgesetzt ist, bei offener Verbindungseinrichtung, ordnet die Weichkomponente der Kappenstruktur die Hartkomponente der Kappenstruktur derart an der Funktionsgehäuse-Anschlussfläche an, dass der Rasthaken der Steckaufnahme am Anschlag des Eingriffselements anschlägt, die Kappenstruktur derart in die erste Öffnung in der Basisgehäuse-Anschlussfläche eingreift, dass der Rahmen der Hartkomponente der Kappenstruktur am Vorsprung in der Basisgehäuse-Anschlussfläche aufliegt und die Außenwandung des Dichtungsstutzens sich derart auf der Weichkomponente der Kappenstruktur abstützt, dass die Funktionsgehäuse-Anschlussfläche von der Basisgehäuse-Anschlussfläche beabstandet ist. Bei geschlossener Verbindungseinrichtung ist die Funktionsgehäuse-Anschlussfläche derart an die Basisgehäuse-Anschlussfläche angepresst, dass die Weichkomponente der Kappenstruktur in Bereichen zwischen dem Vorsprung in der Basisgehäuse-Anschlussfläche und der Außenwandung des Dichtungsstutzens radial verpresst ist und das Eingriffselement der Funktionsgehäuse-Anschlussfläche derart in die Steckaufnahme der Hartkomponente der Kappenstruktur eingeschoben ist, dass der Rasthaken der Steckaufnahme vom Anschlag des Eingriffselements beabstandet ist.

Die im Bereich zwischen dem Vorsprung in der Basisgehäuse-Anschlussfläche und dem Dichtungsstutzen verpresste Weichkomponente bildet vorteilhafterweise eine radiale Dichtung bzw. eine radiale Barriere gegen ein Eindringen von Staub, Feuchtigkeit oder Chemikalien. Ein Vorteil der radialen Dichtung besteht darin, dass die radiale Dichtung zunächst noch nicht verpresst wird, wenn das Funktionsmodul auf das Basismodul aufgesetzt wird. Liegt der Rahmen der Kappenstruktur am Vorsprung in der Basisgehäuse-Anschlussfläche an und ist das Funktionsmodul noch nicht mittels der Verbindungseinrichtung an das Basismodul gepresst, so befindet sich die Weichkomponente in einem nicht verpressten Zustand. Dadurch weist die Funktionsgehäuse-Anschlussfläche zunächst einen Abstand zur Basisgehäuse-Anschlussfläche auf. Das Aufsetzen des Funktionsmoduls kann dadurch mit besonders wenig Kraftaufwand erfolgen, da eine Reibungskraft beim Aufsetzen des Funktionsmoduls reduziert ist. Dadurch können insbesondere große Funktionsmodule mit einer Mehrzahl von radialen Dichtungen mit einem geringen Kraftaufwand auf das Basismodul aufgesetzt werden. Im aufgesetzten Zustand des Funktionsmoduls schlägt der Rasthaken der Steckaufnahme am Anschlag des Eingriffselements an.

Erst wenn die Verbindungseinrichtung geschlossen wird, erfolgt ein Verpressen der Weichkomponente, wodurch eine Dichtwirkung der radialen Dichtung bewirkt wird. In diesem Fall wird die Kappenstruktur um den nach dem Aufsetzen des Funktionsmoduls verbliebenen Abstand bzw. Hub zwischen der Funktionsgehäuse-Anschlussfläche und der Basisgehäuse-Anschlussfläche in das Basisgehäuse geschoben. Dadurch ist der Rasthaken vom Anschlag beabstandet.

Beim Lösen der Verbindungseinrichtung drückt die Weichkomponente gegen das Funktionsmodul bis sich die Weichkomponente auf ihre unverpresste Form ausgedehnt hat, sodass der Hub zwischen Funktionsmodul und Basismodul wieder hergestellt ist. Dadurch wird das Abnehmen des Funktionsmoduls erleichtert. Nach dem Lösen der Verbindungseinrichtung schlägt der Rasthaken wieder am Anschlag an, wodurch die Kappenstruktur beim Abziehen des Funktionsmoduls mitgenommen wird. Insgesamt sind also sowohl die Montage des Funktionsmoduls auf dem Basismodul als auch die Demontage vereinfacht. Die Reibungskräfte sind in beiden Fällen reduziert, wodurch vorteilhafterweise ein Verschleiß der radialen Dichtung reduziert wird.

In einer Ausführungsform weist die Funktionsgehäuse-Anschlussfläche zumindest ein an der zweiten Öffnung und dem Eingriffselement gegenüberliegend angeordnetes weiteres Eingriffselemente auf. Eine Wandung des weiteren Eingriffselements weist eine weitere Aussparung auf. Eine die weitere Aussparung begrenzende weitere Kante der Wandung des weiteren Eingriffselements bildet auf einer von der Funktionsgehäuse-Anschlussfläche abgewandten Seite der weiteren Aussparung einen weiteren Anschlag. Die Hartkomponente weist zumindest eine mit dem Rahmen verbundene weitere Steckaufnahme auf. An einer Wandung der weiteren Steckaufnahme ist ein weiterer Rasthaken angeordnet. Das weitere Eingriffselement ist derart in die weitere Steckaufnahme eingeschoben, dass die Weichkomponente an einer Außenwandung des Dichtungsstutzens anliegt und der weitere Rasthaken in die weitere Aussparung eingreift. Wenn das Funktionsmodul auf dem Basismodul aufgesetzt ist, bei offener Verbindungseinrichtung, ordnet die Weichkomponente der Kappenstruktur die Hartkomponente der Kappenstruktur derart an der Funktionsgehäuse-Anschlussfläche an, dass der weitere Rasthaken der weiteren Steckaufnahme am weiteren Anschlag des weiteren Eingriffselements anschlägt. Bei geschlossener Verbindungseinrichtung ist das weitere Eingriffselement der Funktionsgehäuse-Anschlussfläche derart in die weitere Steckaufnahme der Hartkomponente der Kappenstruktur eingeschoben, dass der weitere Rasthaken der weiteren Steckaufnahme vom weiteren Anschlag des weiteren Eingriffselements beabstandet ist.

Vorteilhafterweise ist die radiale Dichtung gleichmäßiger verpresst, wenn die Funktionsgehäuse-Anschlussfläche zumindest das weitere Eingriffselement aufweist und die Kappenstruktur die weitere Steckaufnahme aufweist, da die Kappenstruktur an sich gegenüberliegenden Seiten auf die Eingriffselemente gesteckt werden. Dadurch, dass zumindest zwei Rasthaken mit der Funktionsgehäuse-Anschlussfläche verbunden sind, kann ein gleichmäßiges Abnehmen des Funktionsmoduls ermöglicht werden, da die Kappenstruktur zumindest an zwei sich gegenüberliegenden Seiten der zweiten Öffnung mitgenommen werden kann, wenn das Funktionsmodul vom Basismodul getrennt wird.

In einer Ausführungsform ist der Dichtungsstutzen zumindest abschnittsweise sich von der Funktionsgehäuse-Anschlussfläche aus verjüngend ausgebildet. Die Weichkomponente der Kappenstruktur liegt im Bereich des sich verjüngenden Abschnitts an der Außenwandung des Dichtungsstutzens an. Vorteilhafterweise wird die radiale Dichtung durch einen sich verjüngenden Dichtungsstutzen effizienter verpresst.

In einer Ausführungsform ist der Dichtungsstutzen mit dem Eingriffselement verbunden ist und wird im Bereich des Eingriffselements durch dieses gebildet oder umläuft das Eingriffselement lateral.

In einer Ausführungsform ist zwischen der Funktionsgehäuse-Anschlussfläche und Seitenwänden des Funktionsgehäuses eine zusätzliche Weichkomponente angeordnet. Wenn das Funktionsmodul auf dem Basismodul aufgesetzt ist, bei offener Verbindungseinrichtung, ist die zusätzliche Weichkomponente an der Basisgehäuse-Anschlussfläche angeordnet und bei geschlossener Verbindungseinrichtung an die Basisgehäuse-Anschlussfläche angepresst. Vorteilhafterweise wird durch die zusätzliche Weichkomponente eine axiale Dichtung bzw. eine axiale Barriere gegen ein Eindringen von Staub, Feuchtigkeit oder Chemikalien gebildet. Außerdem wird im Bereich zwischen den Seitenwänden des Funktionsgehäuses und der Funktionsgehäuse-Anschlussfläche eine radiale Barriere gebildet.

In einer Ausführungsform weisen die Seitenwände des Funktionsgehäuses an einer Innenseite des Funktionsgehäuses einen weiteren Vorsprung auf. Wenn das Funktionsmodul auf dem Basismodul aufgesetzt ist, bei offener Verbindungseinrichtung, liegt die zusätzliche Weichkomponente am weiteren Vorsprung an und ist bei geschlossener Verbindungseinrichtung an den weiteren Vorsprung angepresst. Vorteilhafterweise wird durch die zusätzliche Weichkomponente eine axiale Dichtung bzw. eine axiale Barriere gebildet.

In einer Ausführungsform weist die Funktionsgehäuse-Anschlussfläche einen in Richtung der Seitenwände des Funktionsgehäuses ragenden zusätzlichen Vorsprung auf. Der zusätzliche Vorsprung ist in die zusätzliche Weichkomponente eingebettett. Wenn das Funktionsmodul auf dem Basismodul aufgesetzt ist, bei offener Verbindungseinrichtung, liegt die zusätzliche Weichkomponente am zusätzlichen Vorsprung an und ist bei geschlossener Verbindungseinrichtung an den zusätzlichen Vorsprung angepresst. Vorteilhafterweise wird durch den zusätzlichen Vorsprung sowohl eine axiale Dichtung bzw. eine axiale Barriere als auch eine radiale Dichtung bzw. radiale Barriere gebildet. Die axiale Barriere wird dabei an einer der Basisgehäuse-Anschlussfläche zugewandten Seite der Funktionsgehäuseanschlussfläche und im Bereich des zusätzlichen Vorsprungs gebildet. Die radiale Barriere ist an einer Kante der Funktionsgehäuse-Anschlussfläche ausgebildet.

In einer Ausführungsform ist die Funktionsgehäuse-Anschlussfläche starr mit Seitenwänden des Funktionsgehäuses verbunden. Eine weitere Weichkomponente ist in einer an der Funktionsgehäuse-Anschlussfläche ausgebildeten Nut angeordnet. Wenn das Funktionsmodul auf dem Basismodul aufgesetzt ist, bei offener Verbindungseinrichtung, ist die weitere Weichkomponente an der Basisgehäuse-Anschlussfläche angeordnet und ist bei geschlossener Verbindungseinrichtung an die Basisgehäuse-Anschlussfläche angepresst. Vorteilhafterweise wird durch die weitere Weichkomponente eine axiale Dichtung bzw. eine axiale Barriere gebildet.

Ein Funktionsmodul für eine Automatisierungsplattform weist ein Funktionsgehäuse mit einer Funktionsgehäuse-Anschlussfläche auf. Die Funktionsgehäuse-Anschlussfläche weist zumindest eine zweite Öffnung, zumindest ein an der zweiten Öffnung angeordnetes Eingriffselement und einen um die zweite Öffnung umlaufenden Dichtungsstutzen auf. Eine Wandung des Eingriffselements weist eine Aussparung auf. Eine die Aussparung begrenzende Kante der Wandung des Eingriffselements bildet auf einer von der Funktionsgehäuse-Anschlussfläche abgewandten Seite der Aussparung einen Anschlag. Das Funktionsmodul weist eine Kappenstruktur mit einer Hartkomponente und einer an der Hartkomponente angeordnete Weichkomponente auf. Die Hartkomponente weist einen um die zweite Öffnung umlaufenden Rahmen und zumindest eine mit dem Rahmen verbundene Steckaufnahme auf. Die Weichkomponente der Kappenstruktur ist an einer der Funktionsgehäuse-Anschlussfläche zugewandten Seite des Rahmens angeordnet und umläuft die zweite Öffnung lateral. An einer Wandung der Steckaufnahme ist ein Rasthaken angeordnet. Das Eingriffselement ist derart in die Steckaufnahme eingeschoben, dass die Weichkomponente an einer Außenwandung des Dichtungsstutzens anliegt und der Rasthaken in die Aussparung eingreift. Die Weichkomponente der Kappenstruktur ordnet die Hartkomponente der Kappenstruktur derart an der Funktionsgehäuse-Anschlussfläche an, dass der Rasthaken der Steckaufnahme am Anschlag des Eingriffselements anschlägt. Das Funktionsmodul ist derart auf dem Basismodul aufsetzbar, dass bei offener Verbindungseinrichtung die Kappenstruktur derart in die erste Öffnung in der Basisgehäuse-Anschlussfläche eingreift, dass der Rahmen der Hartkomponente der Kappenstruktur am Vorsprung in der Basisgehäuse-Anschlussfläche aufliegt und die Außenwandung des Dichtungsstutzens sich derart auf der Weichkomponente der Kappenstruktur abstützt, dass die Funktionsgehäuse-Anschlussfläche von der Basisgehäuse-Anschlussfläche beabstandet ist. Bei geschlossener Verbindungseinrichtung ist die Funktionsgehäuse-Anschlussfläche derart an die Basisgehäuse-Anschlussfläche angepresst, dass die Weichkomponente der Kappenstruktur in Bereichen zwischen dem Vorsprung in der Basisgehäuse-Anschlussfläche und der Außenwandung des Dichtungsstutzens radial verpresst ist und das Eingriffselement der Funktionsgehäuse-Anschlussfläche derart in die Steckaufnahme der Hartkomponente der Kappenstruktur eingeschoben ist, dass der Rasthaken der Steckaufnahme vom Anschlag des Eingriffselements beabstandet ist.

In einer Ausführungsform weist die Funktionsgehäuse-Anschlussfläche zumindest ein an der zweiten Öffnung und dem Eingriffselement gegenüberliegend angeordnetes weiteres Eingriffselement auf. Eine Wandung des weiteren Eingriffselements weist eine weitere Aussparung auf. Eine die weitere Aussparung begrenzende weitere Kante der Wandung des weiteren Eingriffselements bildet auf einer von der Funktionsgehäuse-Anschlussfläche abgewandten Seite der weiteren Aussparung einen weiteren Anschlag. Die Hartkomponente weist zumindest eine mit dem Rahmen verbundene weitere Steckaufnahme auf. An einer Wandung der weiteren Steckaufnahme ist ein weiterer Rasthaken angeordnet. Das weitere Eingriffselement ist derart in die weitere Steckaufnahme eingeschoben, dass die Weichkomponente an einer Außenwandung des Dichtungsstutzens anliegt und der weitere Rasthaken in die weitere Aussparung eingreift. Die Weichkomponente der Kappenstruktur ordnet die Hartkomponente der Kappenstruktur derart an der Funktionsgehäuse-Anschlussfläche an, dass der weitere Rasthaken der weiteren Steckaufnahme am weiteren Anschlag des weiteren Eingriffselements anschlägt. Bei geschlossener Verbindungseinrichtung ist das weitere Eingriffselement der Funktionsgehäuse-Anschlussfläche derart in die weitere Steckaufnahme der Hartkomponente der Kappenstruktur eingeschoben, dass der weitere Rasthaken der weiteren Steckaufnahme vom weiteren Anschlag des weiteren Eingriffselements beabstandet ist.

In einer Ausführungsform ist der Dichtungsstutzen zumindest abschnittsweise sich von der Funktionsgehäuse-Anschlussfläche aus verjüngend ausgebildet. Die Weichkomponente der Kappenstruktur liegt im Bereich des sich verjüngenden Abschnitts an der Außenwandung des Dichtungsstutzens an.

In einer Ausführungsform ist der Dichtungsstutzen mit dem Eingriffselement verbunden und wird im Bereich des Eingriffselements durch dieses gebildet oder umläuft das Eingriffselement lateral.

In einer Ausführungsform ist zwischen der Funktionsgehäuse-Anschlussfläche und Seitenwänden des Funktionsgehäuses eine zusätzliche Weichkomponente angeordnet. Wenn das Funktionsmodul auf dem Basismodul aufgesetzt ist, bei offener Verbindungseinrichtung, ist die zusätzliche Weichkomponente an der Basisgehäuse-Anschlussfläche angeordnet und bei geschlossener Verbindungseinrichtung an die Basisgehäuse-Anschlussfläche angepresst.

In einer Ausführungsform weisen die Seitenwände des Funktionsgehäuses an einer Innenseite des Funktionsgehäuses einen weiteren Vorsprung auf. Wenn das Funktionsmodul auf dem Basismodul aufgesetzt ist, bei offener Verbindungseinrichtung, liegt die zusätzliche Weichkomponente am weiteren Vorsprung an und ist bei geschlossener Verbindungseinrichtung an den weiteren Vorsprung angepresst.

In einer Ausführungsform weist die Funktionsgehäuse-Anschlussfläche einen in Richtung der Seitenwände des Funktionsgehäuses ragenden zusätzlichen Vorsprung auf. Der zusätzliche Vorsprung ist in die zusätzliche Weichkomponente eingebettet.

In einer Ausführungsform ist die Funktionsgehäuse-Anschlussfläche starr mit Seitenwänden des Funktionsgehäuses verbunden. Eine weitere Weichkomponente ist in einer an der Funktionsgehäuse-Anschlussfläche ausgebildeten Nut angeordnet. Wenn das Funktionsmodul auf dem Basismodul aufgesetzt ist, bei offener Verbindungseinrichtung, ist die weitere Weichkomponente an der Basisgehäuse-Anschlussfläche angeordnet und bei geschlossener Verbindungseinrichtung an die Basisgehäuse-Anschlussfläche angepresst.

Bei einem Verfahren zum Montieren einer Automatisierungsplattform wird das Funktionsmodul derart auf das Basismodul aufgesetzt, dass die Kappenstruktur derart in die erste Öffnung in der Basisgehäuse-Anschlussfläche eingreift, dass der Rahmen der Hartkomponente der Kappenstruktur am Vorsprung in der Basisgehäuse-Anschlussfläche aufliegt und die Außenwandungen des Dichtungsstutzens sich derart auf der Weichkomponente der Kappenstruktur abstützt, dass die Funktionsgehäuse-Anschlussfläche von der Basisgehäuse-Anschlussfläche beabstandet ist. Die Verbindungseinrichtung wird geschlossen, wodurch die Funktionsgehäuse-Anschlussfläche derart an die Basisgehäuse-Anschlussfläche angepresst wird, dass die Weichkomponente der Kappenstruktur in Bereichen zwischen dem Vorsprung in der Basisgehäuse-Anschlussfläche und der Außenwandung des Dichtungsstutzens radial verpresst wird, und das Eingriffselement der Funktionsgehäuse-Anschlussfläche derart in die Steckaufnahme der Hartkomponente der Kappenstruktur eingeschoben wird, dass der Rasthaken der Steckaufnahme vom Anschlag des Eingriffselements beabstandet ist.

In einer Ausführungsform wird die Verbindungseinrichtung gelöst, wodurch die Weichkomponente derart gegen die Außenwandung des Dichtungsstutzens drückt, dass die Funktionsgehäuse-Anschluss-Fläche von der Basisgehäuse-Anschlussfläche beabstandet ist und der Rasthaken am Anschlag der Eingriffselemente anliegt.

Die Automatisierungsplattform und das Verfahren zum Montieren der Automatisierungsplattform werden im Folgenden im Zusammenhang mit schematischen Zeichnungen detailliert erläutert. Es zeigen:
Fig. 1: eine perspektivische Ansicht auf die Automatisierungsplattform mit einem Basismodul und Funktionsmodulen;
Fig. 2: die Automatisierungsplattform der Fig. 1 in einer Querschnittsansicht;
Fig. 3: die Automatisierungsplattform der Fig. 1 in einer weiteren Querschnittsansicht;
Fig. 4: eine perspektivische Ansicht auf ein Funktionsmodul der Automatisierungsplattform;
Fig. 5: eine perspektivische Ansicht auf ein weiteres Funktionsmodul der Automatisierungsplattform;
Fig. 6: eine Querschnittsansicht des Funktionsmoduls der Fig. 5;
Fig. 7: ein Funktionsmodul und ein Basismodul in einer Querschnittsansicht in einem nicht montierten Zustand der Automatisierungsplattform;
Fig. 8: die Querschnittsansicht der Fig. 7, wobei das Funktionsmodul auf das Basismodul aufgesetzt ist;
Fig. 9: die Querschnittsansicht der Fig. 8, wobei das Funktionsmodul an das Basismodul angepresst ist.

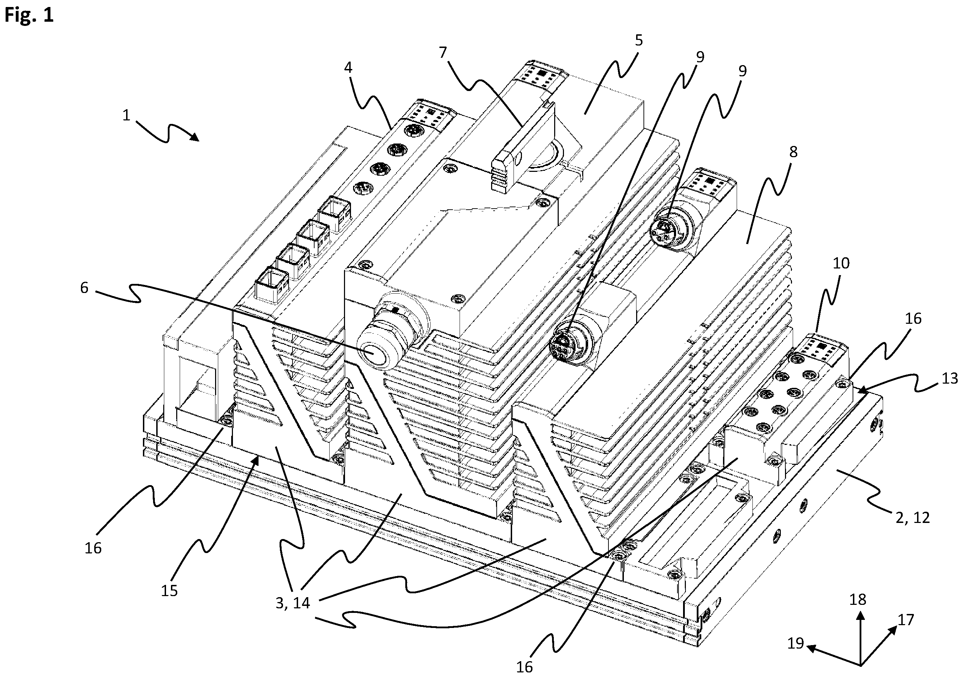

Fig. 1 zeigt schematisch eine beispielhafte Automatisierungsplattform 1 in einer perspektivischen Ansicht. Die Automatisierungsplattform 1 umfasst elektrische und/oder elektronische Komponenten und dient als Verteilersystem für Feldgeräte wie etwa Sensoren und Aktoren. Die Automatisierungsplattform 1 kann beispielsweise in einer Produktionsmaschine verwendet werden. Die Automatisierungsplattform 1 kann einen Schaltschrank ersetzen.

Die Automatisierungsplattform 1 ist modular ausgebildet. Die Automatisierungsplattform 1 weist ein Basismodul 2 und Funktionsmodule 3 auf. Beispielhaft weist die Automatisierungsplattform 1 insgesamt vier Funktionsmodule 3 auf. Die Automatisierungsplattform 1 kann auch eine andere Anzahl von Funktionsmodulen 3 aufweisen, zumindest weist die Automatisierungsplattform 1 jedoch ein Funktionsmodul 3 auf. Lediglich beispielhaft sind die Funktionsmodule 3 unterschiedlich groß ausgebildet.

Ein erstes Funktionsmodul 4 ist beispielhaft als Industrie-PC-Modul ausgebildet. Das Industrie-PC-Modul kann auch als übergeordnetes Modul bezeichnet werden und ist zur Ansteuerung der übrigen Funktionsmodule 3 ausgebildet.

Ein zweites Funktionsmodul 5 ist beispielhaft als Systemmodul ausgebildet. Das Systemmodul weist einen Anschluss 6 zum Einspeisen einer Systemspannung, eine in Fig. 1 nicht dargestellte Sicherung zum Absichern der Systemspannung und einen Hauptschalter 7 zum Schalten der Systemspannung auf.

Ein drittes Funktionsmodul 8 ist beispielhaft als ein Buskoppler ausgebildet. Der Buskoppler weist beispielhaft zwei Anschlüsse 9 mit jeweils einem Dateneingang und einem Datenausgang auf. Die Datenkommunikation kann beispielsweise auf einem Ethernet oder auf einem EtherCAT Protokoll beruhen. Die Datenkommunikation ist jedoch nicht auf die genannten Protokolle beschränkt. Die Anschlüsse 9 des Buskopplers können neben den Dateneingängen und Datenausgängen jeweils einen Spannungseingang und einen Spannungsausgang zum Einkoppeln und Weiterleiten einer elektrischen Spannung aufweisen. Die Datenkommunikation und die elektrische Spannung sind in diesem Fall jeweils über einen gemeinsamen Anschluss 9 einspeisbar, was jedoch nicht erforderlich ist. Es können stattdessen separate Spannungsanschlüsse zum Einspeisen und Weiterleiten elektrischer Spannungen vorgesehen sein.

Das dritte Funktionsmodul 8 kann alternativ auch als ein Relais-Modul zum direkten Schalten einer elektrischen Spannung ausgebildet sein. Ein Relais-Modul kann beispielsweise zur Spannungsversorgung eines Lüfters, einer elektrischen Heizung, einer Beleuchtung und eines Elektromotors, beispielsweise eines Drehstromasynchronmotors, verwendet werden. Alternativ kann das dritte Funktionsmodul 8 auch als Servoverstärker oder Frequenzumrichter ausgebildet sein.

Ein viertes Funktionsmodul 10 des Schaltschranksystems 1 ist beispielhaft als ein I/O-Modul mit Anschlüssen 11 mit analogen und/oder digitalen Dateneingängen und Datenausgängen ausgebildet. Über das I/O-Modul können Feldgeräte angesteuert werden, wie beispielsweise Aktoren und/oder Sensoren.

Das Basismodul 2 weist ein Basisgehäuse 12 mit einer Basisgehäuse-Anschlussfläche 13 auf. Die Funktionsmodule 3 weisen jeweils ein Funktionsgehäuse 14 mit einer Funktionsgehäuse-Anschlussfläche 15 auf. Im montierten Zustand der Automatisierungsplattform 1 sind die Funktionsmodule 3 jeweils mit ihren Funktionsgehäuse-Anschlussflächen 15 an der Basisgehäuse-Anschlussfläche 13 angeordnet und an die Basisgehäuse-Anschlussfläche 13 mittels jeweils einer Verbindungseinrichtung 16 angepresst.

Die Verbindungseinrichtungen 16 sind zum Verbinden der Funktionsmodule 3 mit dem Basismodul 2 ausgebildet. In der beispielhaften Ausführungsform der Automatisierungsplattform 1 umfassen die Verbindungseinrichtungen 16 jeweils eine Mehrzahl von Schrauben pro Funktionsmodul 3, mittels derer die Funktionsmodule 3 an der Basisgehäuse-Anschlussfläche 13 fixiert sind. Die Schrauben erstrecken sich durch die Funktionsmodule 3. Zur Aufnahme der Schrauben weisen die Verbindungseinrichtungen 16 an der Basisgehäuse-Anschlussfläche 13 beispielhaft Sacklöcher mit jeweils einem Gewinde auf. Die Verbindungseinrichtungen 16 können auch anders ausgebildet sein. Beispielsweise können die Verbindungseinrichtungen 16 in Form von Raststrukturen ausgebildet sein, wodurch die Funktionsmodule 3 an der Basisgehäuse-Anschlussfläche 13 einrastbar angeordnet werden können.

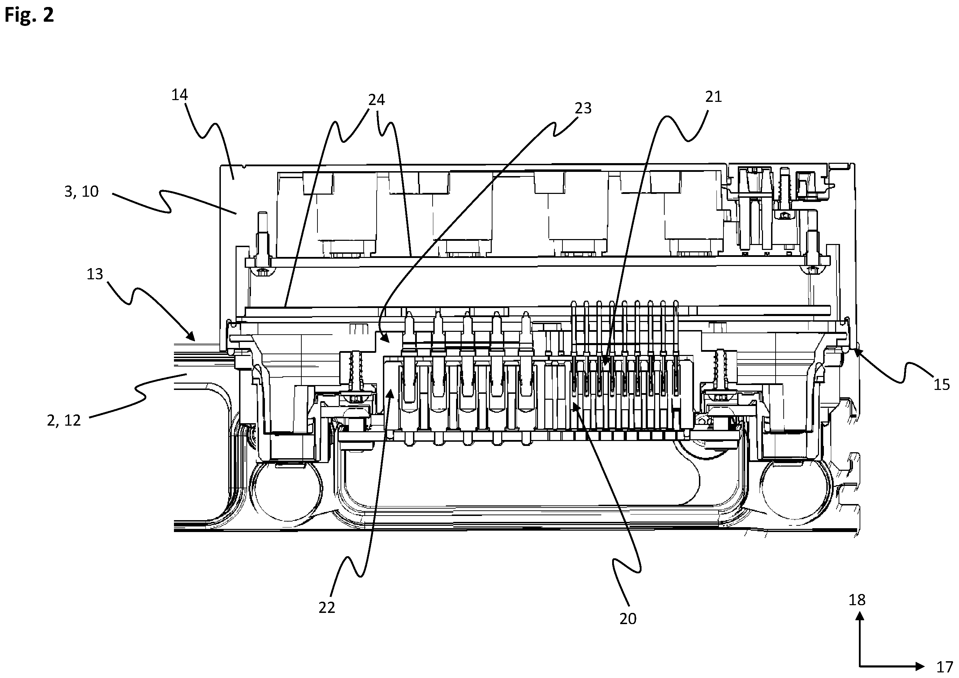

Fig. 2 zeigt schematisch eine Querschnittsansicht der Automatisierungsplattform 1 der Fig. 1 entlang einer von einer ersten Richtung 17 und einer zweiten Richtung 18 aufgespannten und sich längs eines Funktionsmoduls 3 erstreckenden und senkrecht zur Basisgehäuse-Anschlussfläche 13 verlaufenden Ebene. Lediglich beispielhaft ist ein Querschnitt durch das vierte Funktionsmodul 10 gezeigt. Die nachfolgende Beschreibung gilt jedoch entsprechend für alle Funktionsmodule 3. Identische Elemente werden mit denselben Bezugszeichen gekennzeichnet wie in Fig. 1.

Das Basismodul 2 ist dazu vorgesehen, Daten von den Funktionsmodulen 3 zu empfangen und an die Funktionsmodule 3 zu übermitteln. Hierzu weist das Basismodul 2 im Basisgehäuse 12 angeordnete Basisanschlusselemente 20 auf. Die Funktionsmodule 3 weisen jeweils in den Funktionsgehäusen 14 angeordnete Funktionsanschlusselemente 21 auf. Jeweils ein Basisanschlusselement 20 und ein Funktionsanschlusselement 21 greifen im montierten Zustand der Automatisierungsplattform 1 ineinander und bilden jeweils Schnittstellen zwischen dem Basismodul 2 und den Funktionsmodulen 3. Über die Schnittstelle können Daten zwischen dem Basismodul 2 und dem vierten Funktionsmodul 10 ausgetauscht werden. Auch elektrische Spannungen können dem vierten Funktionsmodul 10 vom Basismodul 2 bereitgestellt werden.

Das Basisgehäuse 12 weist an der Basisgehäuse-Anschlussfläche 13 erste Öffnungen 22 auf. Die ersten Öffnungen 22 sind jeweils in Bereichen der Basisanschlusselemente 20 angeordnet. Jeweils ein Basisanschlusselement 20 und eine erste Öffnung 22 bilden einen Steckplatz für ein Funktionsmodul 3. Die Basisanschlusselemente 20 können entweder als Einbaustecker oder als Einbaubuchsen ausgebildet sein. Beispielhaft sind die Basisanschlusselemente 20 der Fig. 2 als Einbaubuchsen ausgebildet. Eine Anzahl von Kontaktöffnungen der Basisanschlusselemente 20 kann beliebig sein.

Das Funktionsgehäuse 14 des vierten Funktionsmoduls 10 weist an seiner Funktionsgehäuse-Anschlussfläche 15 eine zweite Öffnung 23 auf. Im montierten Zustand der Automatisierungsplattform 1, wenn das Funktionsgehäuse 14 mit der Funktionsgehäuse-Anschlussfläche 15 an der Basisgehäuse-Anschlussfläche 13 des Basisgehäuses 12 anliegt, sind die erste Öffnung 22 und die zweite Öffnung 23 übereinander angeordnet. Das Funktionsanschlusselement 21 ist im Bereich der zweiten Öffnung 23 angeordnet und ragt aus dem Funktionsgehäuse 14 heraus. Die Funktionsanschlusselemente 21 können entweder als Einbaustecker oder als Einbaubuchsen ausgebildet sein. Beispielhaft ist das Funktionsanschlusselement 21 des vierten Funktionsmoduls 10 als ein Einbaustecker ausgebildet. Eine Anzahl von Kontaktstiften der Funktionsanschlusselemente 21 kann beliebig sein.

Ein Funktionsgehäuse 14 kann eine beliebige Anzahl von zweiten Öffnungen 23 und in Bereichen der zweiten Öffnungen 23 jeweils angeordnete Funktionsanschlusselemente 21 aufweisen. Beispielsweise erstreckt sich das zweite Funktionsmodul 5 der Fig. 1 über insgesamt sechs Steckplätze des Basismoduls 2. Das zweite Funktionsmodul 5 weist außerdem beispielhaft lediglich vier zweite Öffnungen 23 und zwei Funktionsanschlusselemente 21 auf. Für zwei erste Öffnungen 22 des Basismoduls 2 sind beim zweiten Funktionsmodul 5 keine zweiten Öffnungen 23 vorgesehen. Für zwei der vier zweiten Öffnungen 23 sind hingegen keine Funktionsanschlusselemente 21 vorgesehen. Das erste Funktionsmodul 4 und das dritte Funktionsmodul 8 erstrecken sich hingegen jeweils beispielhaft über vier Steckplätze des Basismoduls 2 und weisen jeweils zwei jeweils im Bereich einer von zwei ersten Öffnung 23 angeordnete Funktionsanschlusselemente 21 auf. Zweite Öffnungen 23, in denen kein Funktionsanschlusselement 21 angeordnet ist, können zur Belüftung des zweiten Funktionsmoduls 5 oder eines beliebigen Funktionsmoduls 3 verwendet werden und können ferner der Führung des Funktionsmoduls 3 bei der Montage dienen.

Erstreckt sich ein Funktionsmodul 3 über mehrere Steckplätze bzw. erste Öffnungen 22 des Basismoduls 2 und weist jedoch eine geringere Anzahl von zweiten Öffnungen 23 und/oder Funktionsanschlusselementen 21 auf, so können Steckplätze des Basismoduls entfallen, d.h. es können zumindest Basisanschlusselemente 20 und gegebenenfalls auch erste Öffnungen 22 entfallen. Beispielsweise können im Fall des zweiten Funktionsmoduls 5 insgesamt vier Steckplätze des Basismoduls 2 entfallen. Anstatt, dass eine erste Öffnung 22 entfällt, wenn kein Basisanschlusselement 20 vorgesehen ist, kann die erste Öffnung 22 auch mit einem Stopfen 57 versiegelt werden. Ein solcher Stopfen 57 kann beispielsweise aus einem Vollmaterial mit einer umlaufenden Nut und einer in der umlaufenden Nut angeordneten O-Ringdichtung ausgeführt sein. Der Stopfen 57 kann auch ein Basisanschlusselement 20 eines Steckplatzes umschließen. Die Stopfen 57 können vor der Montage der Funktionsmodule 3 in unbenutzte Steckplätze des Basismoduls 2 gesteckt werden, um diese abzudichten. Die genannte O-Ringdichtung wird dabei radial durch Formschlüssigkeit mit dem Basisgehäuse 12 komprimiert. Die Funktionsgehäuse-Anschlussfläche 15 eines montierten Funktionsmoduls 3 kann von einem Stopfen 57 beabstandet sein, oder auf dem Stopfen 57 aufliegen und optional auf im montierten Zustand Druck auf den Stopfen 57 ausüben.

Für einen Datenaustausch mit den Funktionsmodulen 3 kann das Basismodul 2 im Basisgehäuse 12 Anschalteinheiten aufweisen, die über einen Datenbus miteinander verbunden sein können. Die in Fig. 1 und Fig. 2 der Übersicht halber nicht gezeigten Anschalteinheiten können beispielsweise als anwendungsspezifische integrierte Schaltungen (ASICs) ausgebildet sein. Die Anschalteinheiten können beispielsweise Bestandteil einer ebenfalls nicht dargestellten Platine des Basismoduls 2 sein. Zur Kommunikation mit den Funktionsmodulen 3 sind die Anschalteinheiten jeweils mit den Basisanschlusselementen 20 verbunden. Die Funktionsanschlusselemente 21 der Funktionsmodule 3 sind wiederum mit Komponenten verbunden, die in den Funktionsgehäusen 14 angeordnet sind. Hierbei kann es sich beispielsweise um Platinen 24 handeln.

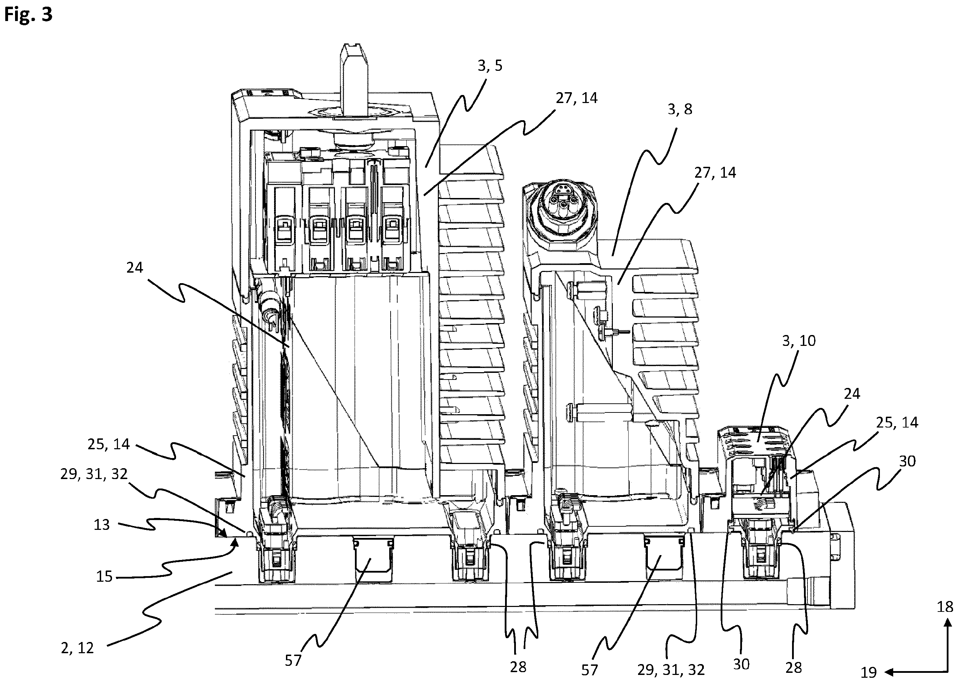

Fig. 3 zeigt schematisch eine Querschnittsansicht der Automatisierungsplattform 1 der Fig. 1 entlang einer von der zweiten Richtung 18 und einer dritten Richtung 19 aufgespannten, senkrecht zur Basisgehäuse-Anschlussfläche 13 und senkrecht zur ersten Richtung 17 verlaufenden Ebene. Lediglich beispielhaft ist ein Querschnitt durch das zweite Funktionsmodul 5, das dritte Funktionsmodul 8 und das vierte Funktionsmodul 10 gezeigt. Identische Elemente werden mit denselben Bezugszeichen gekennzeichnet wie in Fig. 1 und Fig. 2.

Die Funktionsmodule 3 weisen unterschiedliche Typen von Funktionsgehäusen 14 auf. Das zweite Funktionsmodul 5 und das dritte Funktionsmodul 8 weisen jeweils ein Funktionsgehäuse 14 auf, bei dem die Funktionsgehäuse-Anschlussfläche 15 starr mit Seitenwänden 25 des Funktionsgehäuses 14 verbunden sind. Dies gilt auch für das in Fig. 1 nicht dargestellte erste Funktionsmodul 4. Im Gegensatz dazu ist die Funktionsgehäuse-Anschlussfläche 15 des vierten Funktionsmoduls 10 nicht starr mit den Seitenwänden des Funktionsgehäuses 14 verbunden. Stattdessen ist die Funktionsgehäuse-Anschlussfläche 15 des vierten Funktionsmoduls 10 als separate Bodenplatte 26 ausgebildet. Es ist umgekehrt auch möglich, dass das erste Funktionsmodul 4, das zweite Funktionsmodul 5 und das dritte Funktionsmodul 8 jeweils eine separate Bodenplatte 26 aufweisen und beim vierten Funktionsmodul 10 die Funktionsgehäuse-Anschlussfläche 15 starr mit den Seitenwänden 26 des Funktionsgehäuses 14 verbunden ist.

Bei der Variante der Funktionsgehäuse 14 mit jeweils einer starr mit den Seitenwänden 25 verbundenen Funktionsgehäuse-Anschlussfläche 15 weisen die Funktionsgehäuse 14 jeweils eine Haube 27 auf. Eine Haube 27 ermöglicht es, auf einen Bereich im Inneren des Funktionsgehäuses 14 zuzugreifen, um beispielsweise Komponenten im Funktionsgehäuse 14 anzuordnen oder auszutauschen, indem die Haube 27 geöffnet werden kann. Lediglich beispielhaft sind die Funktionsgehäuse 14 des zweiten Funktionsmoduls 5 und des dritten Funktionsmoduls 8 derart ausgebildet, dass die starr mit der Funktionsgehäuse-Anschlussfläche 15 verbundenen Abschnitte der Seitenwände 25 und die Haube 27 jeweils schräg und im Wesentlichen entlang von sich gegenüberliegenden Seitendiagonalen des Funktionsgehäuses 14 voneinander getrennt werden können, was auch in Fig.1 zu erkennen ist. Bei der Variante mit separater Bodenplatte 26 ist das Funktionsgehäuse 14 dadurch zugänglich, dass die Bodenplatte 26 entfernt werden kann.

Die Automatisierungsplattform 1 beruht auf dem Gedanken eines verbesserten Dichtungskonzepts, das im Folgenden näher erläutert wird. Die Automatisierungsplattform 1 muss beispielsweise gegen ein Eindringen von Staub, Feuchtigkeit oder Chemikalien geschützt werden. Dazu weist das Automatisierungssystem 1 jeweils zwischen den Funktionsmodulen 3 und dem Basismodulen 2 angeordnete radiale Dichtungen 28 auf. Die radiale Dichtung 28 ist für jeden Typ von Funktionsmodul 4, 5, 8, 10 identisch ausgebildet.

Die Automatisierungsplattform 1 weist ferner erste axiale Dichtungen 29 und zweite axiale Dichtungen 30 auf. Das erste, zweite und das dritte Funktionsmodul 4, 5, 8 weisen jeweils eine mit den Seitenwänden 25 der Funktionsgehäuse 14 starr verbundene Funktionsgehäuse-Anschlussflächen 15 auf. In diesen Fällen ist jeweils eine erste Weichkomponente 31 in einer an der Funktionsgehäuse-Anschlussfläche 15 ausgebildeten Nut 32 angeordnet. Wenn das erste, zweite und dritte Funktionsmodul 4, 5, 6 auf dem Basismodul 2 aufgesetzt sind und die Verbindungseinrichtungen 16 geöffnet sind, ist die erste Weichkomponente 31 an der Basisgehäuse-Anschlussfläche 13 angeordnet. Bei geschlossenen Verbindungseinrichtungen 16 sind die ersten Weichkomponenten 31 jeweils an die Basisgehäuse-Anschlussfläche 13 angepresst und bilden eine erste axiale Barriere gegen Staub, Feuchtigkeit oder Chemikalien zwischen der Basisgehäuse-Anschlussfläche 13 und der Funktionsgehäuse-Anschlussfläche 15.

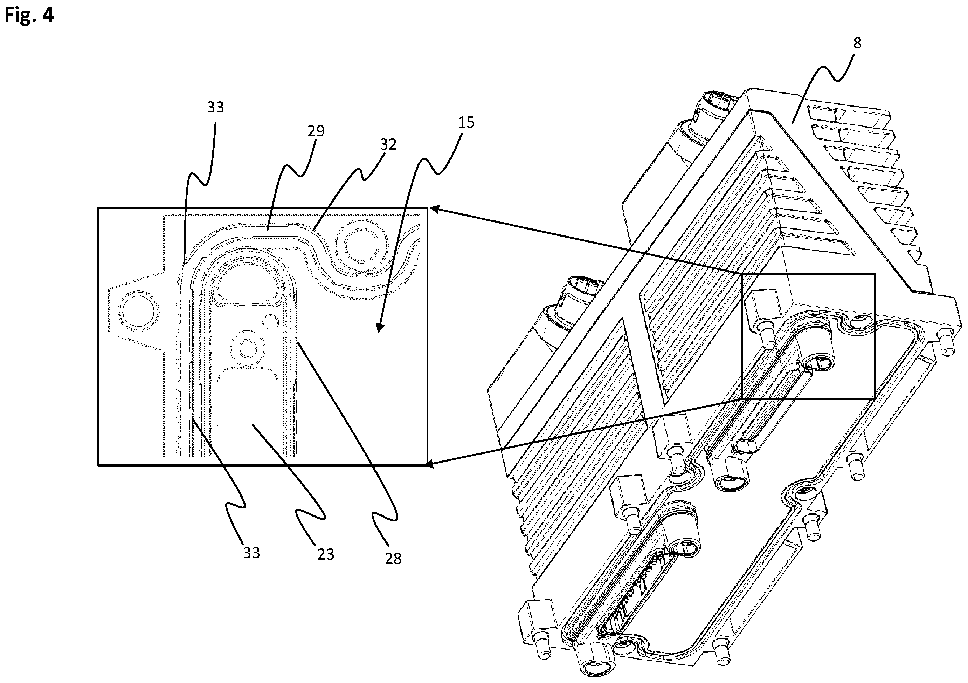

Fig. 4 zeigt schematisch eine perspektivische Ansicht auf das dritte Funktionsmodul 8. Es ist dabei lediglich beispielhaft das dritte Funktionsmodul 8 gezeigt. Die nachfolgende Beschreibung gilt jedoch entsprechend für alle Funktionsmodule 3 mit einer ersten axialen Dichtung 29. Fig. 4 zeigt ferner eine Vergrößerung eines Abschnitts der Funktionsgehäuse-Anschlussfläche 15 mit der ersten axialen Dichtung 29. Identische Elemente werden mit denselben Bezugszeichen gekennzeichnet wie in vorhergehend erläuterten Zeichnungen.

Die in der Nut 32 angeordnete erste Weichkomponente 31 ist beispielhaft als O-Ring ausgebildet. Alternativ kann die erste Weichkomponente 31 auch mittels eines Formverfahrens, beispielsweise mittels eines Spritzgussverfahrens, in der Nut 32 angeordnet werden. Die Nut 32 und die erste Weichkomponente 31 umlaufen die zweiten Öffnungen 23 in der Funktionsgehäuse-Anschlussfläche 15 lateral. Ebenfalls umlaufen die Nut 32 und die erste Weichkomponente 31 alle Funktionsanschlusselemente 21 und alle radialen Dichtungen 28 lateral.

Die erste axiale Dichtung 29 weist zur verbesserten Fixierung der ersten Weichkomponente 31 innerhalb der Nut 32 Haltenoppen 33 auf. Die Haltenoppen 33 werden durch die erste Weichkomponente 31 gebildet. Die Haltenoppen 33 sind beispielhaft abwechselnd auf sich gegenüberliegenden Seiten der ersten Weichkomponente 31 angeordnet, sie können jedoch auch anders angeordnet sein. Die Haltenoppen 33 können jedoch auch entfallen.

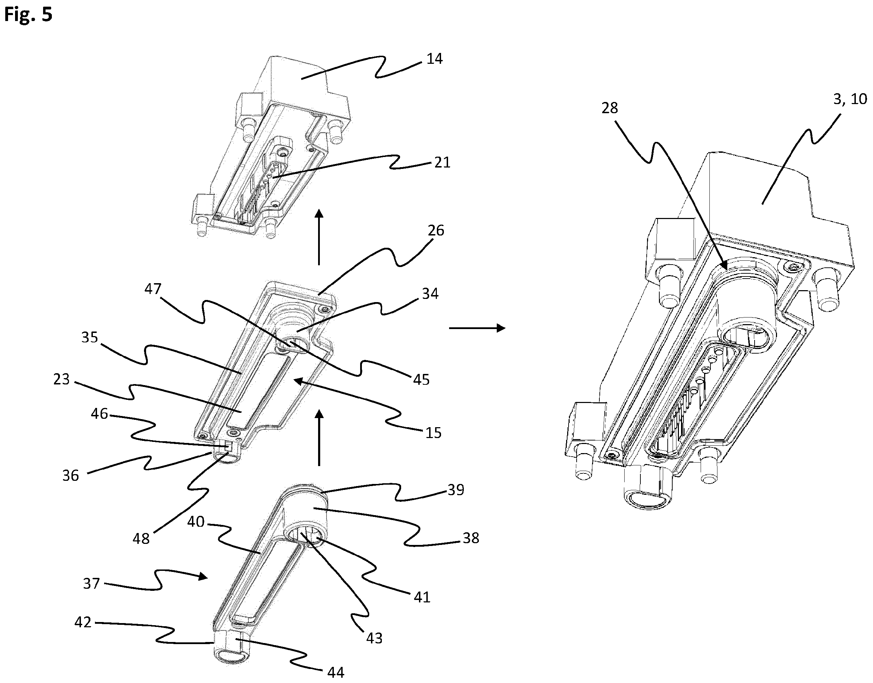

Fig. 5 zeigt schematisch das vierte Funktionsmodul 10 in einer perspektivischen Ansicht, wobei das vierte Funktionsmodul 10 sowohl in einem montierten Zustand, als auch in einem nicht montierten Zustand gezeigt ist. Lediglich beispielhaft zeigt Fig. 5 das vierte Funktionsmodul 10 zur Erläuterung der radialen Dichtungen 28 der Automatisierungsplattform 1. Aus diesem Grund gilt die nachstehende Beschreibung für alle Funktionsmodule 3 und ihre radialen Dichtungen 28 zum Basismodul 2. Identische Elemente werden mit denselben Bezugszeichen gekennzeichnet wie in vorhergehend erläuterten Zeichnungen.

Die Funktionsgehäuse-Anschlussfläche 15 weist zumindest ein an der zweiten Öffnung 23 angeordnetes Eingriffselement 34 und einen um die zweite Öffnung 23 umlaufenden Dichtungsstutzen 35 auf. In der beispielhaften Ausführungsform des Funktionsgehäuses 14 der Fig. 5 weist die Funktionsgehäuse-Anschlussfläche 15 zumindest ein an der zweiten Öffnung 23 und dem Eingriffselement 34 gegenüberliegend angeordnetes weiteres Eingriffselemente 36 auf. Die Funktionsgehäuse-Anschlussfläche 15 kann jedoch auch eine beliebige Anzahl von Eingriffselementen 34, 36 aufweisen, die an der zweiten Öffnung 23 angeordnet sind. Für jede zweite Öffnung 23 ist jedoch zumindest ein Eingriffselement 34, 36 vorgesehen. Weist die Funktionsgehäuse-Anschlussfläche 15 eines Funktionsmoduls 3 eine Mehrzahl von zweiten Öffnungen 23 auf, so ist jeweils zumindest ein Eingriffselement 34 an jeweils einer zweiten Öffnung 23 angeordnet.

Die Eingriffselemente 34, 36 sind beispielhaft zylindrisch ausgeformt. Die Eingriffselemente 34, 36 sind an einer von der Funktionsgehäuse-Anschlussfläche 15 abgewandten Seite geöffnet ausgebildet, wodurch das Funktionsgehäuse 14 zugänglich ist. Dadurch kann Kühlluft zwischen dem Inneren des Basisgehäuses 14 und dem Inneren des Funktionsgehäuses 14 ausgetauscht werden. Aus diesem Grund können die Eingriffselemente 34, 36 auch als Lüftungsstutzen bezeichnet werden. Die Eingriffselemente 34, 36 müssen jedoch nicht zwingender Weise geöffnet und als Lüftungsstutzen ausgebildet sein. Die Eingriffselemente 34, 36 können auch eine andere Form aufweisen. Relevant ist, dass die Eingriffselemente 34, 36 an der Funktionsgehäuse-Anschlussfläche 15 vom Funktionsgehäuse 14 weg ragen.

Der Dichtungsstutzen 35 umläuft die zweite Öffnung 23 lateral und ragt an der Funktionsgehäuse-Anschlussfläche 15 weg vom Funktionsgehäuse 14. Der Dichtungsstutzen 35 ist in der beispielhaften Ausführungsform des Funktionsgehäuses 14 mit den Eingriffselementen 34, 35 starr verbunden und wird in Bereichen der Eingriffselemente 34, 36 durch diese gebildet. In den Bereichen der Eingriffselemente 34, 36 verläuft der Dichtungsstutzen 35 an von der zweiten Öffnung 23 abgewandten Seiten der Eingriffselemente 34, 36. In einer alternativen Ausführungsform umläuft der Dichtungsstutzen 35 auch die Eingriffselemente 34, 36 lateral. In diesem Fall ist der Dichtungsstutzen 35 nicht mit den Eingriffselementen 34, 36 verbunden und wird auch nicht abschnittsweise durch diese gebildet.

Das Funktionsmodul 3 weist ferner eine Kappenstruktur 37 mit einer Hartkomponente 38 und einer an der Hartkomponente 38 angeordneten zweiten Weichkomponente 39 auf. Die Hartkomponente 38 weist einen um die zweite Öffnung 23 umlaufenden Rahmen 40 und zumindest eine mit dem Rahmen 40 verbundene Steckaufnahme 41 auf. Die zweite Weichkomponente 39 der Kappenstruktur 37 ist an einer der Funktionsgehäuse-Anschlussfläche 15 zugewandten Seite des Rahmens 40 angeordnet und umläuft die zweite Öffnung 23 lateral. Durch die zweite Weichkomponente 39 wird die radiale Dichtung 28 gebildet.

Die zweite Weichkomponente 39 kann mittels eines Formverfahrens, beispielsweise mittels eines Spritzgussverfahrens, auf der Hartkomponente 38 angeordnet werden. In diesem Fall sind die Hartkomponente 38 und die zweite Weichkomponente 39 stoffschlüssig miteinander verbunden. Die zweite Weichkomponente 39 kann jedoch alternativ auch als O-Ring ausgebildet sein. Eine stoffschlüssige Verbindung zwischen der Hartkomponente 38 und der zweiten Weichkomponente 39 bietet jedoch den Vorteil, dass das Anordnen der zweiten Weichkomponente 39 auf der Hartkomponente 38 bei der Montage eines Funktionsmoduls 3 bzw. der Automatisierungsplattform 1 entfallen kann.

Es können auch mehrere Steckaufnahmen 41 vorgesehen sein. Zweckmäßigerweise ist die Anzahl der Steckaufnahmen 41 der Kappenstruktur 37 identisch mit der Anzahl der Eingriffselemente 34, 36 der Funktionsgehäuse-Anschlussfläche 15. Aus diesem Grund weist die Kappenstruktur 37 der beispielhaften Ausführungsform gemäß Fig. 5 eine weitere Steckaufnahme 42 auf, die mit dem Rahmen 40 verbunden ist und auf einer der Steckaufnahme 41 gegenüberliegenden Seite des Rahmens 40 angeordnet ist. Die Steckaufnahmen 41, 42 sind an einer vom Rahmen 40 abgewandten Seite geöffnet ausgebildet, wodurch Steckaufnahmen 41, 42 und die Eingriffselemente 34, 36 jeweils als Lüftungsstutzen verwendet werden können, was jedoch nicht zwingend erforderlich ist.

Bei der Montage des Funktionsmoduls 3 wird die Funktionsgehäuse-Anschlussfläche 15 derart am Funktionsgehäuse 14 angeordnet, dass das Funktionsanschlusselement 21 durch die zweite Öffnung 23 in der Funktionsgehäuse-Anschlussfläche 15 aus dem Funktionsgehäuse 14 ragt. Dadurch kann das Funktionsanschlusselement 22 durch eine erste Öffnung 22 in der Basisgehäuse-Anschlussfläche 13 geführt werden, um mit einem Basisanschlusselement 20 verbunden zu werden. Die Steckaufnahmen 41, 42 werden bei der Montage des Funktionsmoduls 3 derart auf die Funktionsgehäuse-Anschlussfläche 15 aufgesteckt, dass die Eingriffselemente 34, 36 jeweils in die Steckaufnahmen 41, 42 eingeschoben sind und in diese eingreifen. Aus diesem Grund weisen die Steckaufnahmen 41, 42 ähnliche geometrische Formen wie die Eingriffselemente 34, 36 auf. An einer Wandung der Steckaufnahmen 41, 42 ist jeweils ein Rasthaken 43, 44 angeordnet ist. Ein Rasthaken 43 der Steckaufnahme 41 und ein weiterer Rasthaken 44 der weiteren Steckaufnahme 44 sind auf sich zugewandten Seiten der Steckaufnahmen 41, 42 angeordnet.

An einer Wandung der Eingriffselemente 34, 36 ist jeweils eine Aussparung 45, 46 angeordnet. Eine Aussparung 45 des Eingriffselements 34 und eine weitere Aussparung 46 des weiteren Eingriffselements 36 sind auf sich zugewandten Seiten der Eingriffselemente 34, 36 angeordnet. Ist lediglich ein Eingriffselement 34 und entsprechend lediglich eine Steckaufnahme 41 vorgesehen, so sind die Aussparung 45 und der Rasthaken 43 jeweils an einer der zweiten Öffnung 23 zugewandten Seite des Eingriffselements 34 bzw. der Steckaufnahme 41 angeordnet. Die Eingriffselemente 34, 36 werden derart in die Steckaufnahme 41, 42 eingeschoben, dass die zweite Weichkomponente 39 an einer Außenwandung des Dichtungsstutzens 35 anliegt und die Rasthaken 43, 44 der Steckaufnahmen 41, 42 jeweils in eine Aussparung 45, 46 der Eingriffselemente 34, 36 eingreifen.

Eine jeweils die Aussparungen 45, 46 begrenzende Kante der Wandungen der Eingriffselemente bildet auf jeweils von der Funktionsgehäuse-Anschlussfläche 15 abgewandten Seiten der Aussparungen 45, 16 jeweils einen Anschlag 47, 48.

Wenn das Funktionsmodul 3 auf dem Basismodul 2 aufgesetzt ist und die Verbindungseinrichtung 16 zwischen dem Funktionsgehäuse 14 und dem Basisgehäuse 12 geöffnet ist, ordnet die zweite Weichkomponente 39 der Kappenstruktur 37 die Hartkomponente 38 der Kappenstruktur 38 derart an der Funktionsgehäuse-Anschlussfläche 15 an, dass die Rasthaken 43, 44 der Steckaufnahmen 41, 42 jeweils an einem Anschlag 47, 18 der Eingriffselemente 34, 36 anschlagen. Der Rasthaken 43 schlägt am Anschlag 47 an. Der weitere Rasthaken 44 schlägt am weiteren Anschlag 48 an.

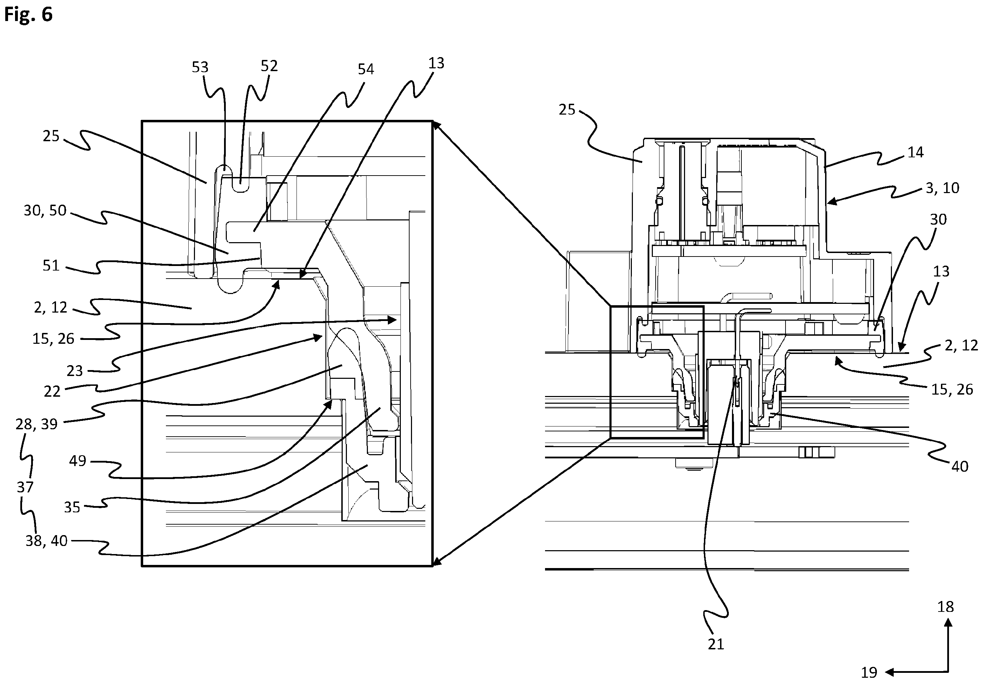

Fig. 6 zeigt schematisch eine Querschnittsansicht der Automatisierungsplattform 1 entsprechend der Darstellung der Fig. 3, wobei jedoch lediglich das vierte Funktionsmodul 10 und das Basismodul 2 gezeigt sind. Das vierte Funktionsmodul 10 ist in Fig. 6 detaillierter gezeigt als in Fig. 3. Fig. 6 zeigt lediglich beispielhaft das vierte Funktionsmodul 10, um das Prinzip der radialen Dichtungen 28 der Automatisierungsplattform 1 näher zu erläutern. Die Automatisierungsplattform 1 weist jedoch für jedes andere Funktionsmodul 10 zumindest eine solche radiale Dichtung 28 auf, die zwischen dem Basismodul 2 und dem Funktionsmodul 3 angeordnet ist. Fig. 6 zeigt auch eine Vergrößerung im Bereich der radialen Dichtung 28 Identische Elemente werden mit denselben Bezugszeichen gekennzeichnet wie in vorhergehend erläuterten Zeichnungen.

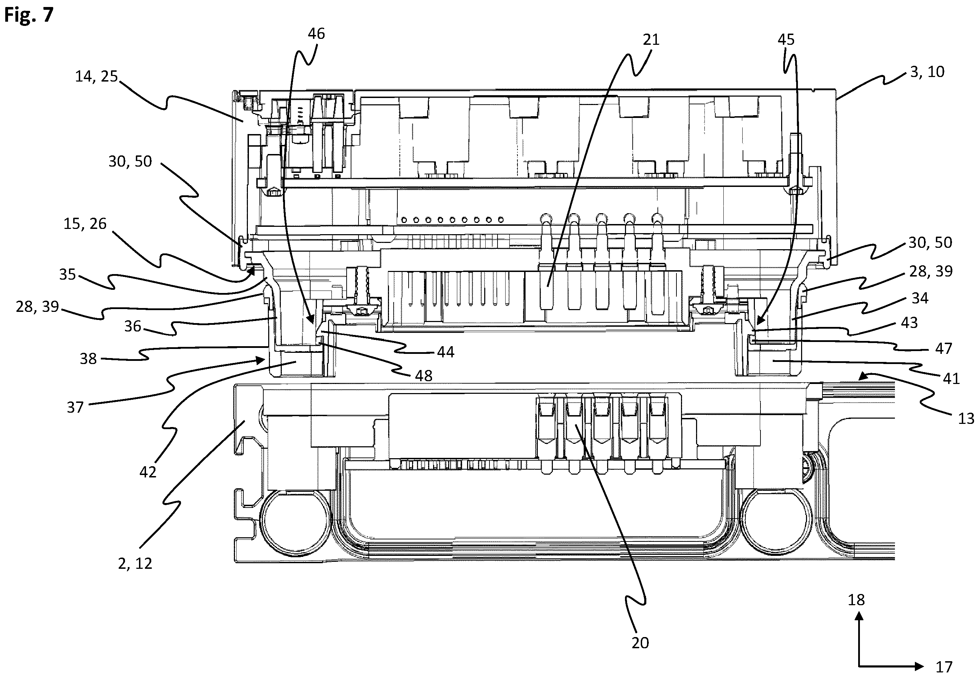

In der Basisgehäuse-Anschlussfläche 13 ist ein um die erste Öffnung 22 umlaufender Vorsprung 49 ausgebildet. Der Vorsprung 49 ist an einer dem Inneren des Basisgehäuses 12 zugewandten Seite der Basisgehäuse-Anschlussfläche 13 angeordnet. Der Vorsprung 49 kann auch als Sitz bezeichnet werden. Wenn das Funktionsmodul 3 auf dem Basismodul 2 aufgesetzt ist, bei offener Verbindungseinrichtung 16, greift die Kappenstruktur 37 derart in die erste Öffnung 22 in der Basisgehäuse-Anschlussfläche 13 ein, dass der Rahmen 40 der Hartkomponente 38 der Kappenstruktur 37 am Vorsprung 49 in der Basisgehäuse-Anschlussfläche 13 aufliegt und die Außenwandung des Dichtungsstutzens 35 sich derart auf der zweiten Weichkomponente 39 der Kappenstruktur 37 abstützt, dass die Funktionsgehäuse-Anschlussfläche 15 von der Basisgehäuse-Anschlussfläche 13 beabstandet ist. Dies ist in Fig. 6 nicht dargestellt, da in diesem Fall die Automatisierungsplattform 1 im montierten Zustand gezeigt ist, wobei die Verbindungseinrichtung 16 geschlossen ist. Ein Abstand zwischen der Basisgehäuse-Anschlussfläche 13 und der Funktionsgehäuse-Anschlussfläche 15 bei auf dem Basismodul 2 aufgesetztem Funktionsmodul 3 und bei offener Verbindungseinrichtung 16 kann auch als Hub bezeichnet werden. Der Hub und seine Wirkung wird im Rahmen der Beschreibung des Verfahrens zum Montieren der Automatisierungsplattform 1 gemäß der Figuren 7 bis 9 näher erläutert. Soll ein Steckplatz mit einem Stopfen 57 abgedichtet werden, kann der Vorsprung 49 als ein Anschlag bzw. als eine Tiefenbegrenzung für den Stopfen 57 dienen.

Bei geschlossener Verbindungseinrichtung 16 gemäß Fig. 6 ist die Funktionsgehäuse-Anschlussfläche 15 derart an die Basisgehäuse-Anschlussfläche 13 angepresst, dass die zweite Weichkomponente 39 der Kappenstruktur 37 in Bereichen zwischen dem Vorsprung 49 in der Basisgehäuse-Anschlussfläche 13 und der Außenwandung des Dichtungsstutzens 35 radial verpresst ist und die Eingriffselemente 34, 36 der Funktionsgehäuse-Anschlussfläche 15 sind jeweils derart in die Steckaufnahmen 41, 42 der Hartkomponente 38 der Kappenstruktur 37 eingeschoben, dass die Rasthaken 43, 44 der Steckaufnahmen 41, 42 jeweils vom Anschlag 47, 48 der Eingriffselemente 34, 36 beabstandet sind.

Die zweite Weichkomponente 39 liegt am Dichtungsstutzen 35 an, wodurch eine erste radiale Barriere gegen Staub, Feuchtigkeit oder Chemikalien gebildet wird. Der Dichtungsstutzen 35 kann wie in der beispielhaften Ausführungsform der Fig. 6 zumindest abschnittsweise sich von der Funktionsgehäuse-Anschlussfläche 15 aus verjüngend ausgebildet sein. Die zweite Weichkomponente 39 der Kappenstruktur 37 liegt im Bereich des sich verjüngenden Abschnitts an der Außenwandung des Dichtungsstutzens 35 an. Dadurch kann ein effizienteres Verpressen der zweiten Weichkomponente 39 bewirkt werden. Außerdem liegt die zweite Weichkomponente 39 über dem Vorsprung 39 an einer Wandung an, die die erste Öffnung 22 in der Basisgehäuse-Anschlussfläche 13 begrenzt. Dadurch wird eine zweite radiale Barriere gebildet. Fig. 6 zeigt die zweite Dichtung 28 sowohl in einem komprimiertem als auch in einem unkomprimierten Zustand, um die Dichtwirkung zu verdeutlichen. Ein in Fig. 6 mit dem Dichtungsstutzen 35 überlappender Abschnitt der zweiten Weichkomponente 39 deutet dabei eine Geometrie der zweiten Weichkomponente 39 im unkomprimierten Zustand an. In komprimierten Zustand erstreckt sich die zweite Weichkomponente 39 lediglich bis zum Dichtungsstutzen 35.

Beim vierten Funktionsmodul 10 ist die Funktionsgehäuse-Anschlussfläche 15 als separate Bodenplatte 26 ausgebildet. Aus diesem Grund ist eine zweite axiale Dichtung 30 vorgesehen. Zwischen der Funktionsgehäuse-Anschlussfläche 15 und Seitenwänden 25 des Funktionsgehäuses 14 ist eine dritte Weichkomponente 50 angeordnet. Die dritte Weichkomponente 50 kann beispielsweise mittels eines Formverfahrens, beispielsweise mittels eines Spritzgussverfahrens, an einer Kante 51 der Funktionsgehäuse-Anschlussfläche 15 angeordnet werden. Alternativ kann die dritte Weichkomponente 50 auf die Kante 51 der Funktionsgehäuse-Anschlussfläche 15 aufgesteckt werden.

Wenn das vierte Funktionsmodul 10 auf dem Basismodul 2 aufgesetzt ist, bei offener Verbindungseinrichtung 16, ist die dritte Weichkomponente 50 an der Basisgehäuse-Anschlussfläche 13 angeordnet und bei geschlossener Verbindungseinrichtung 16 an die Basisgehäuse-Anschlussfläche 13 angepresst. Dadurch wird eine zweite axiale Barriere gegen Staub, Feuchtigkeit oder Chemikalien gebildet. Außerdem liegt die dritte Weichkomponente 50 an den Seitenwänden 25 des Funktionsgehäuses 14 an, wodurch eine dritte radiale Barriere gebildet wird.

Gemäß der beispielhaften Ausführungsform des vierten Funktionsmoduls 10 weisen die Seitenwände 25 des Funktionsgehäuses 14 an einer Innenseite des Funktionsgehäuses 14 einen weiteren Vorsprung 52 auf. Beispielhaft ist zwischen dem weiteren Vorsprung 52 und den Seitenwänden 25 eine nutförmige Aussparung 53 ausgeformt, die jedoch auch entfallen kann. Wenn das vierte Funktionsmodul 10 auf dem Basismodul 2 aufgesetzt ist, bei offener Verbindungseinrichtung 16, liegt die dritte Weichkomponente 50 am weiteren Vorsprung 52 an. Bei geschlossener Verbindungseinrichtung 16 ist die dritte Weichkomponente 50 an den weiteren Vorsprung 52 angepresst. Dadurch wird eine dritte axiale Barriere gebildet. Der weitere Vorsprung 52 muss jedoch nicht zwingender Weise vorgesehen sein und kann auch entfallen. Auch die dritte Weichkomponente 50 ist in Fig. 6 in einem komprimiertem als auch in einem unkomprimierten Zustand gezeigt, um die Dichtwirkung zu verdeutlichen. Ein in Fig. 6 mit dem Vorsprung 52 überlappender Abschnitt der dritten Weichkomponente 50 deutet dabei den unkomprimierten Zustand an.

Die Funktionsgehäuse-Anschlussfläche 15 weist ferner einen in Richtung der Seitenwände 25 des Funktionsgehäuses 14 ragenden zusätzlichen Vorsprung 54 auf. Der zusätzliche Vorsprung 54 ist in die dritte Weichkomponente 50 eingebettet. Wenn das vierte Funktionsmodul 10 auf dem Basismodul 2 aufgesetzt ist, bei offener Verbindungseinrichtung 16, liegt die dritte Weichkomponente 50 am zusätzlichen Vorsprung 54 an. Bei geschlossener Verbindungseinrichtung 16 ist die dritte Weichkomponente 50 an den zusätzlichen Vorsprung 54 angepresst. Dadurch werden eine vierte axiale Barriere und eine fünfte axiale Barriere gebildet. Die vierte axiale Barriere ist an einer von der Basisgehäuse-Anschlussfläche 13 abgewandten Seite der Funktionsgehäuse-Anschlussfläche 15 ausgebildet. Die fünfte axiale Barriere ist an einer der Basisgehäuse-Anschlussfläche 13 zugewandten Seite der Funktionsgehäuse-Anschlussfläche 15 ausgebildet. Außerdem wird eine dritte radiale Barriere in einem Bereich gebildet, in dem die dritte Weichkomponente 50 an der Kante 51 der Funktionsgehäuse-Anschlussfläche 15 angepresst ist, wenn die Funktionsgehäuse-Anschlussfläche 15 mit den Seitenwänden 25 des Funktionsgehäuses verbunden ist.

Fig. 7 bis 9 zeigen schematisch zeitlich aufeinanderfolgende Zustände im Rahmen eines Verfahrens zum Montieren der Automatisierungsplattform 1 jeweils entsprechend der Querschnittsansicht der Fig. 2. Lediglich beispielhaft wird das vierte Funktionsmodul 10 gezeigt, um die Wirkung der radialen Dichtung 28 bei der Montage zu erläutern.

Fig. 7 zeigt einen Zustand, bei dem das Funktionsmodul 3 und das Basismodul 3 voneinander separiert sind. In diesem Fall ordnet die zweite Weichkomponente 39 der Kappenstruktur 37 die Hartkomponente 38 der Kappenstruktur 37 derart an der Funktionsgehäuse-Anschlussfläche 15 an, dass die Rasthaken 43, 44 der Steckaufnahmen 41, 42 jeweils am Anschlag 47, 48 der Eingriffselemente 34, 36 anschlagen.

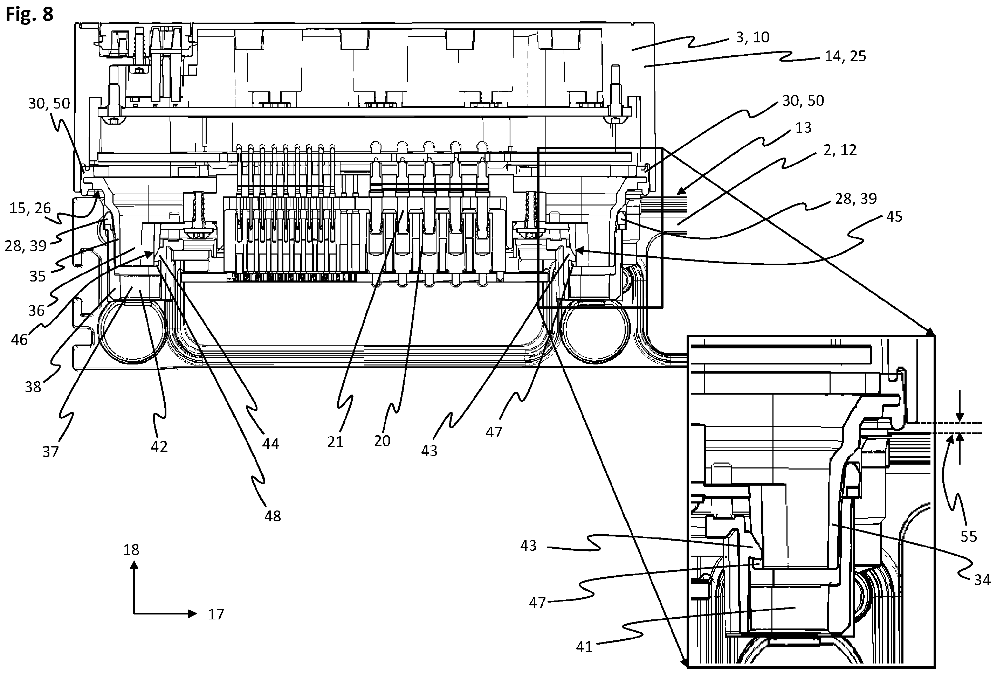

Fig. 8 zeigt einen der Fig. 7 zeitlich nachfolgenden Zustand nachdem das Funktionsmodul 3 auf das Basismodul 2 aufgesetzt wurde. Die Verbindungseinrichtung 16 ist jedoch in einem geöffneten Zustand. Das Funktionsmodul 3 liegt also lediglich am Basismodul 2 an und ist noch nicht an das Basismodul 2 angepresst.

Auch in diesem Fall ordnet die zweite Weichkomponente 39 der Kappenstruktur 37 die Hartkomponente 38 der Kappenstruktur 37 derart an der Funktionsgehäuse-Anschlussfläche 15 an, dass die Rasthaken 43, 44 der Steckaufnahmen 41, 42 jeweils am Anschlag 47, 48 der Eingriffselemente 34, 36 anschlagen. Dies liegt daran, dass die zweite Weichkomponente 39 noch nicht verpresst ist, da die Verbindungseinrichtung 16 geöffnet ist.

Die Kappenstruktur 37 greift derart in die erste Öffnung 22 in der Basisgehäuse-Anschlussfläche 13 ein, dass der Rahmen 40 der Hartkomponente 38 der Kappenstruktur 37 am Vorsprung 49 in der Basisgehäuse-Anschlussfläche 13 aufliegt und die Außenwandungen des Dichtungsstutzens 35 sich derart auf der zweiten Weichkomponente 39 der Kappenstruktur 37 abstützt, dass die Funktionsgehäuse-Anschlussfläche 15 von der Basisgehäuse-Anschlussfläche 13 beabstandet ist. Dieser Abstand kann auch als Hub 55 bezeichnet werden.

Fig. 8 zeigt auch eine Vergrößerung eines Bereichs des Rasthakens 43, der am Anschlag 47 anliegt. In der Vergrößerung ist auch der Hub 55 zwischen der Basisgehäuse-Anschlussfläche 13 und der Funktionsgehäuseanschlussfläche 15 gezeigt. Der Hub 55 ist ebenfalls eine Folge der Tatsache, dass die zweite Weichkomponente 39 in diesem Zustand noch nicht verpresst ist.

Dadurch bleibt die zweite Weichkomponente 39 während des Steckens bzw. Aufsetzen des Funktionsmoduls 3 in einem unverpressten Zustand, sodass das Funktionsmodul 3 nahezu reibungslos und somit kraftlos aufgesetzt werden kann.

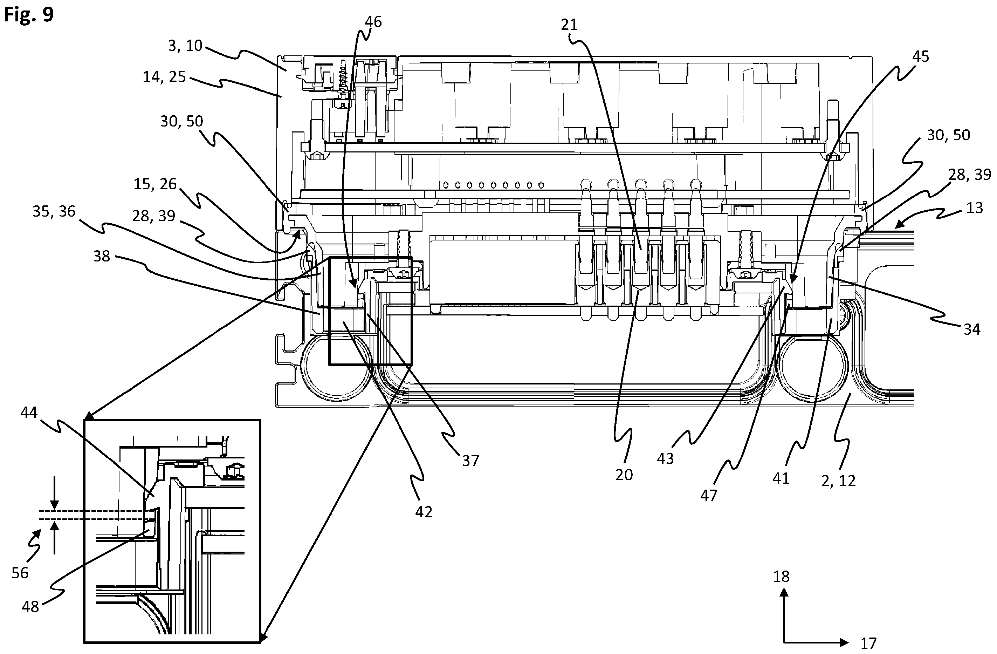

Fig. 9 zeigt einen der Fig. 8 zeitlich nachfolgenden Zustand, nachdem die Verbindungseinrichtung 16 geschlossen wurde, wodurch das Funktionsmodul 3 mit dem Basismodul 2 verbunden wurde. Wie in Fig. 6 zeigt auch Fig. 9 die zweite Dichtung 28 im komprimierten und im unkomprimierten Zustand, weshalb der mit dem Dichtungsstutzen 35 überlappende Abschnitt der zweiten Weichkomponente 39 auch in Fig. 9 dargestellt ist und die Geometrie der zweiten Weichkomponente 39 im unkomprimierten Zustand andeutet.

Durch das Schließen der Verbindungseinrichtung 16 wurde die Funktionsgehäuse-Anschlussfläche 15 derart an die Basisgehäuse-Anschlussfläche 13 angepresst, dass die zweite Weichkomponente 39 der Kappenstruktur 37 in Bereichen zwischen dem Vorsprung 49 in der Basisgehäuse-Anschlussfläche 13 und der Außenwandung des Dichtungsstutzens 35 radial verpresst wurde. Die Eingriffselemente 34, 36 der Funktionsgehäuse-Anschlussfläche 15 wurden dabei derart in die Steckaufnahmen 41, 42 der Hartkomponente 38 der Kappenstruktur 37 eingeschoben, dass die Rasthaken 43, 44 der Steckaufnahme 41, 42 jeweils von den Anschlägen 47, 48 der Eingriffselemente 34, 36 beabstandet sind. Fig. 9 zeigt eine Vergrößerung im Bereich eines der Rasthaken 44 und einen Abstand 56 zum betreffenden Anschlag 48. Das Funktionsmodul 3 wird also erst kurz bevor die Funktionsgehäuse-Anschlussfläche 15 auf der Basisgehäuse-Anschlussfläche 13 anliegt durch die Verbindungseinrichtung 16 auf Endposition gezogen. Erst dann entsteht damit eine Dichtwirkung der radialen Dichtung 28. Dadurch kann das Aufsetzen des Funktionsmoduls 3 mit wenig Kraftaufwand erfolgen. Dies kann das Stecken bzw. Aufsetzen besonders großer Funktionsmodule 3 mit einer Mehrzahl von Funktionsanschlusselementen 21 und radialen Dichtungen 28 vereinfachen. Außerdem ist ein Verschleiß der radialen Dichtung 28 bei der Montage geringer.

Wird die Verbindungseinrichtung 16 wieder geöffnet bzw. gelöst drückt die zweite Weichkomponente 39 derart gegen die Außenwandung des Dichtungsstutzens 35, dass die Funktionsgehäuse-Anschlussfläche 15 von der Basisgehäuse-Anschlussfläche 13 beabstandet ist und die Rasthaken 43, 44 an den Anschlägen 47, 48 der Eingriffselemente 34, 36 anliegen. Wenn ein von der Verbindungseinrichtung 16 auf die zweite Weichkomponente erzeugter Druck wegfällt, drückt die zweite Weichkomponente 39 das Funktionsgehäuse 14 also in den nicht montierten Zustand und es besteht keine große Reibung mehr zwischen dem Funktionsmodul 3 und dem Basismodul 2. Beim Lösen der Verbindungseinrichtung 16 drückt die zweite Weichkomponente 39 schon mit einer Kraftkomponente gegen das Funktionsmodul 3, sodass das Lösen des Funktionsmoduls unterstützt wird und mit wenig Kraftaufwand erfolgen kann. Erst dann kann die Kappenstruktur 37 über den Rasthaken 43, 44 mitgenommen werden. Durch den Hub 55 kann das Funktionsmodul 3 also wieder einfacher vom Basismodul 2 gelöst werden, indem das Funktionsmodul 3 schon entsprechend dem Hub 55 abgezogen werden kann, die Kappenstruktur 37 aber zunächst an ihrer Position bleibt, da die Rasthaken 43, 44 von den Anschlägen 47, 48 zunächst beabstandet sind.

### BEZUGSZEICHENLISTE

- 1: Automatisierungsplattform
- 2: Basismodul
- 3: Funktionsmodul
- 4: Erstes Funktionsmodul
- 5: Zweites Funktionsmodul
- 6: Spannungsanschluss
- 7: Hauptschalter
- 8: Drittes Funktionsmodul
- 9: Datenanschluss
- 10: Viertes Funktionsmodul
- 11: Analoge und/oder Digitale Datenanschlüsse
- 12: Basisgehäuse
- 13: Basisgehäuse-Anschlussfläche
- 14: Funktionsgehäuse
- 15: Funktionsgehäuse-Anschlussfläche
- 16: Verbindungseinrichtung
- 17: Erste Richtung
- 18: Zweite Richtung
- 19: Dritte Richtung
- 20: Basisanschlusselement
- 21: Funktionsanschlusselement
- 22: Erste Öffnung im Basisgehäuse
- 23: Zweite Öffnung im Funktionsgehäuse
- 24: Platine
- 25: Seitenwände des Funktionsgehäuses
- 26: Bodenplatte des Funktionsmoduls
- 27: Haube eines Funktionsgehäuses
- 28: Radiale Dichtung
- 29: Erste axiale Dichtung
- 30: Zweite axiale Dichtung
- 31: Erste Weichkomponente
- 32: Nut an der Funktionsgehäuse-Anschlussfläche
- 33: Haltenoppen der ersten Weichkomponente
- 34: Eingriffselement der Funktionsgehäuse-Anschlussfläche
- 35: Dichtungsstutzen der Funktionsgehäuse-Anschlussfläche
- 36: Weiteres Eingriffselement der Funktionsgehäuse-Anschlussfläche
- 37: Kappenstruktur des Funktionsmoduls
- 38: Hartkomponente der Kappenstruktur
- 39: Zweite Weichkomponente der Kappenstruktur
- 40: Rahmen der Kappenstruktur
- 41: Steckaufnahme
- 42: Weitere Steckaufnahme
- 43: Rasthaken der Steckaufnahme
- 44: Weiterer Rasthaken der weiteren Steckaufnahme
- 45: Aussparung im Eingriffselement
- 46: Weitere Aussparung im weiteren Eingriffselement
- 47: Anschlag
- 48: Weiterer Anschlag
- 49: Vorsprung in der Basisgehäuse-Anschlussfläche
- 50: Dritte Weichkomponente
- 51: Kante der Funktionsgehäuse-Anschlussfläche
- 52: Weiterer Vorsprung an den Seitenwänden des Funktionsgehäuses
- 53: Nutförmige Aussparung zwischen dem weiteren Vorsprung und den Seitenwänden des Funktionsgehäuses
- 54: Zusätzlicher Vorsprung in der Funktionsgehäuse-Anschlussfläche
- 55: Hub zwischen Basisgehäuse-Anschlussfläche und Funktionsgehäuse-Anschlussfläche
- 56: Abstand zwischen Rasthaken und Anschlag
- 57: Stopfen

## Patentansprüche

1. Funktionsmodul (3, 4, 5, 8, 10) für eine Automatisierungsplattform (1),
wobei ein Basismodul (2) und zumindest eine Verbindungseinrichtung (16) zum Verbinden von Basismodul (2) und Funktionsmodul (3, 4, 5, 8, 10) vorgesehen ist,
wobei das Basismodul (2) ein Basisgehäuse (12) mit einer Basisgehäuse-Anschlussfläche (13) aufweist,
wobei die Basisgehäuse-Anschlussfläche (13) zumindest eine erste Öffnung (22) aufweist,
wobei das Funktionsmodul (3, 4, 5, 8, 10) ein Funktionsgehäuse (14) mit einer Funktionsgehäuse-Anschlussfläche (15) aufweist,
wobei die Funktionsgehäuse-Anschlussfläche (15) zumindest eine zweite Öffnung (23) und zumindest ein an der zweiten Öffnung (23) angeordnetes Eingriffselement (34) aufweist,
wobei das Funktionsmodul (3, 4, 5, 8, 10) eine Kappenstruktur (37) mit einer Hartkomponente (38) und einer an der Hartkomponente (38) angeordnete Weichkomponente (39) aufweist,
wobei die Hartkomponente (38) einen um die zweite Öffnung (23) umlaufenden Rahmen (40) und zumindest eine mit dem Rahmen (40) verbundene Steckaufnahme (41) aufweist, wobei die Weichkomponente (39) der Kappenstruktur (37) die zweite Öffnung (23) lateral umläuft,
**dadurch gekennzeichnet,**
**dass** die Funktionsgehäuse-Anschlussfläche (15) einen um die zweite Öffnung (23) umlaufenden Dichtungsstutzen (35) aufweist, wobei eine Wandung des Eingriffselements (34) eine Aussparung (45) aufweist, wobei eine die (45) Aussparung begrenzende Kante der Wandung des Eingriffselements (34) auf einer von der Funktionsgehäuse-Anschlussfläche (15) abgewandten Seite der Aussparung (45) einen Anschlag (47) bildet,
**dass** die Weichkomponente (39) der Kappenstruktur (37) an einer der Funktionsgehäuse-Anschlussfläche (15) zugewandten Seite des Rahmens (40) angeordnet ist,
**dass** an einer Wandung der Steckaufnahme (41) ein Rasthaken (43) angeordnet ist, wobei das Eingriffselement (34) derart in die Steckaufnahme (41) eingeschoben ist, dass die Weichkomponente (39) an einer Außenwandung des Dichtungsstutzens (35) anliegt und der Rasthaken (43) in die Aussparung (45) eingreift,
wobei die Weichkomponente (39) der Kappenstruktur (37) die Hartkomponente (38) der Kappenstruktur (37) derart an der Funktionsgehäuse-Anschlussfläche (15) anordnet, dass der Rasthaken (43) der Steckaufnahme (41) am Anschlag (47) des Eingriffselements (34) anschlägt,
**dass** das Funktionsmodul (3, 4, 5, 8, 10) derart auf dem Basismodul (2) aufsetzbar ist,
**dass** bei offener Verbindungseinrichtung (16) die Kappenstruktur (37) derart in die erste Öffnung (22) in der Basisgehäuse-Anschlussfläche (13) eingreift, dass der Rahmen (40) der Hartkomponente (38) der Kappenstruktur (37) am Vorsprung (49) in der Basisgehäuse-Anschlussfläche (13) aufliegt und die Außenwandung des Dichtungsstutzens (35) sich derart auf der Weichkomponente (39) der Kappenstruktur (37) abstützt, dass die Funktionsgehäuse-Anschlussfläche (15) von der Basisgehäuse-Anschlussfläche (13) beabstandet ist und, bei geschlossener Verbindungseinrichtung (16), die Funktionsgehäuse-Anschlussfläche (15) derart an die Basisgehäuse-Anschlussfläche (13) angepresst ist, dass die Weichkomponente (39) der Kappenstruktur (37) in Bereichen zwischen dem Vorsprung (49) in der Basisgehäuse-Anschlussfläche (13) und der Außenwandung des Dichtungsstutzens (35) radial verpresst ist und das Eingriffselement (34) der Funktionsgehäuse-Anschlussfläche (15) derart in die Steckaufnahme (41) der Hartkomponente (38) der Kappenstruktur (37) eingeschoben ist, dass der Rasthaken (43) der Steckaufnahme (41) vom Anschlag (47) des Eingriffselements (34) beabstandet ist.

2. Funktionsmodul (3, 4, 5, 8, 10) gemäß Anspruch 1,
wobei die Funktionsgehäuse-Anschlussfläche (15) zumindest ein an der zweiten Öffnung (23) und dem Eingriffselement (34) gegenüberliegend angeordnetes weiteres Eingriffselement (36) aufweist,
wobei eine Wandung des weiteren Eingriffselements (36) eine weitere Aussparung (46) aufweist,
wobei eine die weitere Aussparung (46) begrenzende weitere Kante der Wandung des weiteren Eingriffselements (36) auf einer von der Funktionsgehäuse-Anschlussfläche (15) abgewandten Seite der weiteren Aussparung (46) einen weiteren Anschlag (48) bildet, wobei die Hartkomponente (38) zumindest eine mit dem Rahmen (40) verbundene weitere Steckaufnahme (42) aufweist,
wobei an einer Wandung der weiteren Steckaufnahme (42) ein weiterer Rasthaken (44) angeordnet ist,
wobei das weitere Eingriffselement (36) derart in die weitere Steckaufnahme (42) eingeschoben ist, dass die Weichkomponente (39) an einer Außenwandung des Dichtungsstutzens (35) anliegt und der weitere Rasthaken (44) in die weitere Aussparung (46) eingreift, wobei die Weichkomponente (39) der Kappenstruktur (37) die Hartkomponente (38) der Kappenstruktur (37) derart an der Funktionsgehäuse-Anschlussfläche (15) anordnet, dass der weitere Rasthaken (44) der weiteren Steckaufnahme (42) am weiteren Anschlag (48) des weiteren Eingriffselements (36) anschlägt,
wobei bei geschlossener Verbindungseinrichtung (16) das weitere Eingriffselement (36) der Funktionsgehäuse-Anschlussfläche (15) derart in die weitere Steckaufnahme (42) der Hartkomponente (38) der Kappenstruktur (37) eingeschoben ist, dass der weitere Rasthaken (44) der weiteren Steckaufnahme (42) vom weiteren Anschlag (48) des weiteren Eingriffselements (36) beabstandet ist.

3. Funktionsmodul (3, 4, 5, 8, 10) gemäß Anspruch 1 oder 2,
wobei der Dichtungsstutzen (35) zumindest abschnittsweise sich von der Funktionsgehäuse-Anschlussfläche (15) aus verjüngend ausgebildet ist,
wobei die Weichkomponente (39) der Kappenstruktur (37) im Bereich des sich verjüngenden Abschnitts an der Außenwandung des Dichtungsstutzens (35) anliegt.

4. Funktionsmodul (3, 4, 5, 8, 10) gemäß einem der vorhergehenden Ansprüche, wobei der Dichtungsstutzen (35) mit dem Eingriffselement (34, 36) verbunden ist und im Bereich des Eingriffselements (34, 36) durch dieses gebildet wird oder das Eingriffselement (34, 36) lateral umläuft.

5. Funktionsmodul (3, 10) gemäß einem der vorhergehenden Ansprüche,
wobei zwischen der Funktionsgehäuse-Anschlussfläche (15) und Seitenwänden (25) des Funktionsgehäuses (14) eine zusätzliche Weichkomponente (50) angeordnet ist,
wobei, wenn das Funktionsmodul (3, 10) auf dem Basismodul (2) aufgesetzt ist, bei offener Verbindungseinrichtung (16), die zusätzliche Weichkomponente (50) an der Basisgehäuse-Anschlussfläche (13) angeordnet und bei geschlossener Verbindungseinrichtung (16) an die Basisgehäuse-Anschlussfläche (13) angepresst ist.

6. Funktionsmodul (3, 10) gemäß Anspruch 5,
wobei die Seitenwände (25) des Funktionsgehäuses (14) an einer Innenseite des Funktionsgehäuses (14) einen weiteren Vorsprung (52) aufweisen,
wobei, wenn das Funktionsmodul (3, 10) auf dem Basismodul (2) aufgesetzt ist, bei offener Verbindungseinrichtung (16), die zusätzliche Weichkomponente (50) am weiteren Vorsprung (52) anliegt und bei geschlossener Verbindungseinrichtung (16) an den weiteren Vorsprung (52) angepresst ist.

7. Funktionsmodul (3, 10) gemäß Anspruch 5 oder 6,
wobei die Funktionsgehäuse-Anschlussfläche (15) einen in Richtung der Seitenwände (25) des Funktionsgehäuses (14) ragenden zusätzlichen Vorsprung (54) aufweist,
wobei der zusätzliche Vorsprung (54) in die zusätzliche Weichkomponente (50) eingebettet ist.

8. Funktionsmodul (3, 4, 5, 8) gemäß einem der Ansprüche 1 bis 4,
wobei die Funktionsgehäuse-Anschlussfläche (15) starr mit Seitenwänden (25) des Funktionsgehäuses (14) verbunden ist,
wobei eine weitere Weichkomponente (31) in einer an der Funktionsgehäuse-Anschlussfläche (15) ausgebildeten Nut (32) angeordnet ist,
wobei, wenn das Funktionsmodul (3, 4, 5, 8) auf dem Basismodul (2) aufgesetzt ist, bei offener Verbindungseinrichtung (16), die weitere Weichkomponente (31) an der Basisgehäuse-Anschlussfläche (13) angeordnet und bei geschlossener Verbindungseinrichtung (16) an die Basisgehäuse-Anschlussfläche (13) angepresst ist.

9. Automatisierungsplattform (1)
mit einem Basismodul (2), zumindest einem Funktionsmodul (3, 4, 5, 8, 10) gemäß einem der vorhergehenden Ansprüche, und zumindest einer Verbindungseinrichtung (16) zum Verbinden von Basismodul (2) und Funktionsmodul (3, 4, 5, 8, 10),
wobei das Basismodul (2) ein Basisgehäuse (12) mit einer Basisgehäuse-Anschlussfläche (13) aufweist,
wobei die Basisgehäuse-Anschlussfläche (13) zumindest eine erste Öffnung (22) aufweist,
wobei in der Basisgehäuse-Anschlussfläche (13) ein um die erste Öffnung (22) umlaufender Vorsprung (49) ausgebildet ist,
wobei das Funktionsmodul (3, 4, 5, 8, 10) auf dem Basismodul (2) aufgesetzt ist, und wobei bei offener Verbindungseinrichtung (16), die Weichkomponente (39) der Kappenstruktur (37) die Hartkomponente (38) der Kappenstruktur (37) derart an der Funktionsgehäuse-Anschlussfläche (15) anordnet, dass der Rasthaken (43) der Steckaufnahme (41) am Anschlag (47) des Eingriffselements (34) anschlägt, die Kappenstruktur (37) derart in die erste Öffnung (22) in der Basisgehäuse-Anschlussfläche (13) eingreift, dass der Rahmen (40) der Hartkomponente (38) der Kappenstruktur (37) am Vorsprung (49) in der Basisgehäuse-Anschlussfläche (13) aufliegt und die Außenwandung des Dichtungsstutzens (35) sich derart auf der Weichkomponente (39) der Kappenstruktur (37) abstützt, dass die Funktionsgehäuse-Anschlussfläche (15) von der Basisgehäuse-Anschlussfläche (13) beabstandet ist, und bei geschlossener Verbindungseinrichtung (16), die Funktionsgehäuse-Anschlussfläche (15) derart an die Basisgehäuse-Anschlussfläche (13) angepresst ist,
dass die Weichkomponente (39) der Kappenstruktur (37) in Bereichen zwischen dem Vorsprung (49) in der Basisgehäuse-Anschlussfläche (13) und der Außenwandung des Dichtungsstutzens (35) radial verpresst ist und das Eingriffselement (34) der Funktionsgehäuse-Anschlussfläche (15) derart in die Steckaufnahme (41) der Hartkomponente (38) der Kappenstruktur (37) eingeschoben ist, dass der Rasthaken (43) der Steckaufnahme (41) vom Anschlag (47) des Eingriffselements (34) beabstandet ist.

10. Automatisierungsplattform (1) gemäß Anspruch 9, sofern abhängig von Anspruch 2,
wobei das Funktionsmodul (3, 4, 5, 8, 10) auf dem Basismodul (2) aufgesetzt ist, und wobei bei offener Verbindungseinrichtung (16), die Weichkomponente (39) der Kappenstruktur (37) die Hartkomponente (38) der Kappenstruktur (37) derart an der Funktionsgehäuse-Anschlussfläche (15) anordnet, dass der weitere Rasthaken (44) der weiteren Steckaufnahme (42) am weiteren Anschlag (48) des weiteren Eingriffselements (36) anschlägt,
wobei bei geschlossener Verbindungseinrichtung (16) das weitere Eingriffselement (36) der Funktionsgehäuse-Anschlussfläche (15) derart in die weitere Steckaufnahme (42) der Hartkomponente (38) der Kappenstruktur (37) eingeschoben ist, dass der weitere Rasthaken (44) der weiteren Steckaufnahme (42) vom weiteren Anschlag (48) des weiteren Eingriffselements (36) beabstandet ist.

11. Automatisierungsplattform (1) gemäß Anspruch 9, sofern abhängig von Anspruch 5,
wobei zwischen der Funktionsgehäuse-Anschlussfläche (15) und Seitenwänden (25) des Funktionsgehäuses (14) eine zusätzliche Weichkomponente (50) angeordnet ist,
wobei, wenn das Funktionsmodul (3, 10) auf dem Basismodul (2) aufgesetzt ist, bei offener Verbindungseinrichtung (16), die zusätzliche Weichkomponente (50) an der Basisgehäuse-Anschlussfläche (13) angeordnet und bei geschlossener Verbindungseinrichtung (16) an die Basisgehäuse-Anschlussfläche (13) angepresst ist.

12. Automatisierungsplattform (1) gemäß Anspruch 9, sofern abhängig von Anspruch 6,
wobei, wenn das Funktionsmodul (3, 10) auf dem Basismodul (2) aufgesetzt ist, bei offener Verbindungseinrichtung (16), die zusätzliche Weichkomponente (50) am weiteren Vorsprung (52) anliegt und bei geschlossener Verbindungseinrichtung (16) an den weiteren Vorsprung (52) angepresst ist.

13. Automatisierungsplattform (1) gemäß Anspruch 9, sofern abhängig von Anspruch 7,
wobei das Funktionsmodul (3, 10) auf dem Basismodul (2) aufgesetzt ist, und wobei bei offener Verbindungseinrichtung (16), die zusätzliche Weichkomponente (50) am zusätzlichen Vorsprung (54) anliegt und bei geschlossener Verbindungseinrichtung (16) an den zusätzlichen Vorsprung (54) angepresst ist.

14. Automatisierungsplattform (1) gemäß Anspruch 9, sofern abhängig von den Ansprüche 1 bis 4,
wobei das Funktionsmodul (3, 4, 5, 8) auf dem Basismodul (2) aufgesetzt ist, und wobei bei offener Verbindungseinrichtung (16), die weitere Weichkomponente (31) an der Basisgehäuse-Anschlussfläche (13) angeordnet und bei geschlossener Verbindungseinrichtung (16) an die Basisgehäuse-Anschlussfläche (13) angepresst ist.

15. Verfahren zum Montieren einer Automatisierungsplattform (1) gemäß einem der Ansprüche 9 bis 14 mit folgenden Verfahrensschritten:
- Aufsetzen des Funktionsmoduls (3, 4, 5, 8, 10) auf das Basismodul (2) derart, dass die Kappenstruktur (37) derart in die erste Öffnung (22) in der Basisgehäuse-Anschlussfläche (13) eingreift, dass der Rahmen (40) der Hartkomponente (38) der Kappenstruktur (37) am Vorsprung (49) in der Basisgehäuse-Anschlussfläche (13) aufliegt und die Außenwandungen des Dichtungsstutzens (35) sich derart auf der Weichkomponente (39) der Kappenstruktur (37) abstützt, dass die Funktionsgehäuse-Anschlussfläche (15) von der Basisgehäuse-Anschlussfläche (13) beabstandet ist,
- Schließen der Verbindungseinrichtung (16), wodurch die Funktionsgehäuse-Anschlussfläche (15) derart an die Basisgehäuse-Anschlussfläche (13) angepresst wird, dass die Weichkomponente (39) der Kappenstruktur (37) in Bereichen zwischen dem Vorsprung (49) in der Basisgehäuse-Anschlussfläche (13) und der Außenwandung des Dichtungsstutzens (35) radial verpresst wird, und das Eingriffselement (34) der Funktionsgehäuse-Anschlussfläche (15) derart in die Steckaufnahme (41) der Hartkomponente (38) der Kappenstruktur (27) eingeschoben wird, dass der Rasthaken (43) der Steckaufnahme (41) vom Anschlag (47) des Eingriffselements (34) beabstandet ist
und optional den folgenden weiteren Verfahrensschritt:
- Lösen der Verbindungseinrichtung (16), wodurch die Weichkomponente (39) derart gegen die Außenwandung des Dichtungsstutzens (35) drückt, dass die Funktionsgehäuse-Anschlussfläche (15) von der Basisgehäuse-Anschlussfläche (13) beabstandet ist und der Rasthaken (43) am Anschlag (47) des Eingriffselements (34) anliegt.

## Claims

1. A functional module (3, 4, 5, 8, 10) for an automation platform (1),
wherein a base module (2) and at least a connecting device (16) for connecting a base module (2) and a functional module (3, 4, 5, 8, 10) is provided,
wherein the base module (2) comprises a base housing (12) having a base housing connection surface (13),
wherein the base housing connection surface (13) comprises at least a first opening (22),
wherein the functional module (3, 4, 5, 8, 10) comprises a functional housing (14) having a functional housing connection surface (15),
wherein the functional housing connection surface (15) comprises at least one second opening (23) and at least one engagement element (34) arranged at the second opening (23),
wherein the functional module (3, 4, 5, 8, 10) comprises a cap structure (37) having a hard component (38) and a soft component (39) arranged on the hard component (38),
wherein the hard component (38) comprises a frame (40) running around the second opening (23) and at least one plug-in receptacle (41) connected to the frame (40),
wherein the soft component (39) of the cap structure (37) runs laterally around the second opening (23),
**characterized in that**
the functional housing connection surface (15) comprises a sealing socket (35) running around the second opening (23) , wherein a wall of the engagement element (34) comprises a recess (45), wherein an edge of the wall of the engagement element (34) delimiting the recess (45) forms a stop (47) on a side of the recess (45) facing away from the functional housing connection surface (15),
the soft component (39) of the cap structure (37) is arranged on a side of the frame (40) facing the functional housing connection surface (15) a latching hook (43) is arranged on a wall of the plug-in receptacle (41), wherein the engagement element (34) is inserted into the plug-in receptacle (41) in such a way that the soft component (39) rests against an outer wall of the sealing socket (35) and the latching hook (43) engages in the recess (45),
wherein the soft component (39) of the cap structure (37) arranges the hard component (38) of the cap structure (37) at the functional housing connection surface (15) in such a way that the latching hook (43) of the plug-in receptacle (41) abuts on the stop (47) of the engagement element (34),
the functional module (3, 4, 5, 8, 10) may be placed onto the base module (2) in such a way that, when the connecting device (16) is open, the cap structure (37) engages in the first opening (22) in the base housing connection surface (13), that the frame (40) of the hard component (38) of the cap structure (37) rests on the projection (49) in the base housing connection surface (13) and the outer wall of the sealing socket (35) is supported on the soft component (39) of the cap structure (37) in such a way that the functional housing connection surface (15) is spaced apart from the base housing connection surface (13) and, when the connecting device (16) is closed, the functional housing connecting surface (15) is pressed against the base housing connecting surface (13) in such a way that the soft component (39) of the cap structure (37) is radially pressed in regions between the projection (49) in the base housing connection surface (13) and the outer wall of the sealing socket (35) and the engagement element (34) of the functional housing connection surface (15) is pushed into the plug-in receptacle (41) of the hard component (38) of the cap structure (37) in such a way that the latching hook (43) of the plug-in receptacle (41) is spaced apart from the stop (47) of the engagement element (34).

2. The functional module (3, 4, 5, 8, 10) according to claim 1,
wherein the functional housing connection surface (15) comprises at least one further engagement element (36) arranged opposite to the second opening (23) and the engagement element (34),
wherein a wall of the further engagement element (36) comprises a further recess (46),
wherein a further edge of the wall of the further engagement element (36) delimiting the further recess (46) forms a further stop (48) on a side of the further recess (46) facing away from the functional housing connection surface (15),
wherein the hard component (38) comprises at least one further plug-in receptacle (42) connected to the frame (40),
wherein a further latching hook (44) is arranged on a wall of the further plug-in receptacle (42),
wherein the further engagement element (36) is inserted into the further plug-in receptacle (42) in such a way that the soft component (39) rests against an outer wall of the sealing socket (35) and the further latching hook (44) engages in the further recess (46),
wherein the soft component (39) of the cap structure (37) arranges the hard component (38) of the cap structure (37) on the functional housing connection surface (15) in such a way that the further latching hook (44) of the further plug-in receptacle (42) abuts on the further stop (48) of the further engagement element (36),
wherein, when the connecting device (16) is closed, the further engagement element (36) of the functional housing connection surface (15) is inserted into the further plug-in receptacle (42) of the hard component (38) of the cap structure (37) in such a way that the further latching hook (44) of the further plug-in receptacle (42) is spaced apart from the further stop (48) of the further engagement element (36).

3. The functional module (3, 4, 5, 8, 10) according to claim 1 or 2,
wherein the sealing socket (35) is embodied to taper at least in sections originating from the functional housing connection surface (15),
wherein the soft component (39) of the cap structure (37) bears against the outer wall of the sealing socket (35) in the region of the tapering section.

4. The functional module (3, 4, 5, 8, 10) according to any one of the preceding claims,
wherein the sealing socket (35) is connected to the engagement element (34, 36) and is formed by the latter in the region of the engagement element (34, 36) or laterally runs around the engagement element (34, 36).

5. The functional module (3, 10) according to any one of the preceding claims,
wherein an additional soft component (50) is arranged between the functional housing connection surface (15) and side walls (25) of the functional housing (14), wherein, when the functional module (3, 10) is placed onto the base module (2), the additional soft component (50) is arranged on the base housing connection surface (13) when the connecting device (16) is open and is pressed against the base housing connection surface (13) when the connecting device (16) is closed.

6. The functional module (3, 10) according to claim 5,
wherein the side walls (25) of the functional housing (14) comprise a further projection (52) at an inner side of the functional housing (14),
wherein, when the functional module (3, 10) is placed onto the base module (2), the additional soft component (50) rests against the further projection (52) when the connecting device (16) is open and is pressed against the further projection (52) when the connecting device (16) is closed.

7. The functional module (3, 10) according to claim 5 or 6,
wherein the functional housing connection surface (15) comprises an additional projection (54) protruding towards the side walls (25) of the functional housing (14),
wherein the additional projection (54) is embedded in the additional soft component (50).

8. The functional module (3, 4, 5, 8) according to any one of claims 1 to 4,
wherein the functional housing connection surface (15) is rigidly connected to side walls (25) of the functional housing (14),
wherein a further soft component (31) is arranged in a groove (32) embodied on the functional housing connection surface (15),
wherein, when the functional module (3, 4, 5, 8) is placed onto the base module (2), the further soft component (31) is arranged on the base housing connection surface (13) when the connecting device (16) is open and is pressed against the base housing connection surface (13) when the connecting device (16) is closed.

9. An automation platform (1)
having a base module (2), at least one functional module (3, 4, 5, 8, 10) according to any one of the preceding claims, and at least one connecting device (16) for connecting the base module (2) and the functional module (3, 4, 5, 8, 10),
wherein the base module (2) comprises a base housing (12) having a base housing connection surface (13),
wherein the base housing connection surface (13) comprises at least one first opening (22),
wherein a projection (49) running around the first opening (22) is embodied in the base housing connection surface (13),
wherein the functional module (3, 4, 5, 8, 10) is placed onto the base module (2),
and wherein, when the connecting device (16) is open, the soft component (39) of the cap structure (37) arranges the hard component (38) of the cap structure (37) at the functional housing connection surface (15) in such a way that the latching hook (43) of the plug-in receptacle (41) abuts on the stop (47) of the engagement element (34), the cap structure (37) engages in the first opening (22) in the base housing connection surface (13) in such a way that the frame (40) of the hard component (38) of the cap structure (37) rests on the projection (49) in the base housing connection surface (13) and the outer wall of the sealing socket (35) is supported on the soft component (39) of the cap structure (37) in such a way that the functional housing connection surface (15) is spaced apart from the base housing connection surface (13) and, when the connecting device (16) is closed, the functional housing connecting surface (15) is pressed against the base housing connecting surface (13) in such a way that the soft component (39) of the cap structure (37) is radially pressed in regions between the projection (49) in the base housing connection surface (13) and the outer wall of the sealing socket (35) and the engagement element (34) of the functional housing connection surface (15) is inserted into the plug-in receptacle (41) of the hard component (38) of the cap structure (37) in such a way that the latching hook (43) of the plug-in receptacle (41) is spaced apart from the stop (47) of the engagement element (34).

10. The automation platform (1) according to claim 9, insofar as it depends upon claim 2,
wherein the functional module (3, 4, 5, 8, 10) is placed onto the base module (2), and wherein, with the connecting device (16) open, the soft component (39) of the cap structure (37) arranges the hard component (38) of the cap structure (37) on the functional housing connection surface (15) in such a way that the further latching hook (44) of the further plug-in receptacle (42) abuts on the further stop (48) of the further engagement element (36),
wherein, when the connecting device (16) is closed, the further engagement element (36) of the functional housing connection surface (15) is inserted into the further plug-in receptacle (42) of the hard component (38) of the cap structure (37) in such a way that the further latching hook (44) of the further plug-in receptacle (42) is spaced apart from the further stop (48) of the further engagement element (36).

11. The automation platform (1) according to claim 9, insofar as it depends upon claim 5,
wherein an additional soft component (50) is arranged between the functional housing connection surface (15) and side walls (25) of the functional housing (14), wherein, when the functional module (3, 10) is placed onto the base module (2), the additional soft component (50) is arranged on the base housing connection surface (13) when the connecting device (16) is open and is pressed against the base housing connection surface (13) when the connecting device (16) is closed.

12. The automation platform (1) according to claim 9, as far as it depends upon claim 6,
wherein, when the functional module (3, 10) is placed onto the base module (2), the additional soft component (50) rests against the further projection (52) when the connecting device (16) is open and is pressed against the further projection (52) when the connecting device (16) is closed.

13. The automation platform (1) according to claim 9, as far as it depends upon claim 7,
wherein the functional module (3, 10) is placed onto the base module (2), and
wherein the additional soft component (50) rests against the additional projection (54) when the connecting device (16) is open and is pressed against the additional projection (54) when the connecting device (16) is closed.

14. The automation platform (1) according to claim 9, insofar as it depends upon claims 1 to 4,
wherein the functional module (3, 4, 5, 8) is placed onto the base module (2), and
wherein the further soft component (31) is arranged on the base housing connection surface (13) when the connecting device (16) is open and is pressed against the base housing connection surface (13) when the connecting device (16) is closed.

15. A method for assembling an automation platform (1) according to any one of claims 9 to 14, comprising the following method steps:
- placing the functional module (3, 4, 5, 8, 10) onto the base module (2) in such a way that the cap structure (37) engages in the first opening (22) in the base housing connection surface (13) in such a way that the frame (40) of the hard component (38) of the cap structure (37) rests on the projection (49) in the base housing connection surface (13) and the outer walls of the sealing socket (35) are supported on the soft component (39) of the cap structure (37) in such a way that the functional housing connection surface (15) is spaced apart from the base housing connection surface (13),
- closing the connecting device (16), wherein the functional housing connection surface (15) is pressed against the base housing connection surface (13) in such a way that the soft component (39) of the cap structure (37) is radially pressed in regions between the projection (49) in the base housing connection surface (13) and the outer wall of the sealing socket (35), and the engagement element (34) of the functional housing connection surface (15) is inserted into the plug-in receptacle (41) of the hard component (38) of the cap structure (27) in such a way that the latching hook (43) of the plug-in receptacle (41) is spaced apart from the stop (47) of the engagement element (34),
and optionally the following further method step:
- releasing the connecting device (16), as a result of which the soft component (39) presses against the outer wall of the sealing socket (35) in such a way that the functional housing connection surface (15) is spaced apart from the base housing connection surface (13) and the latching hook (43) rests against the stop (47) of the engagement element (34).

## Revendications

1. Module fonctionnel (3, 4, 5, 8, 10) pour une plateforme d'automatisation (1),
un module de base (2) et au moins un dispositif de liaison (16) étant prévus pour relier le module de base (2) et le module fonctionnel (3, 4, 5, 8, 10),
le module de base (2) présentant un boîtier de base (12) avec une surface de raccordement de boîtier de base (13), la surface de raccordement de boîtier de base (13) présentant au moins une première ouverture (22),
le module fonctionnel (3, 4, 5, 8, 10) présentant un boîtier fonctionnel (14) avec une surface de raccordement de boîtier fonctionnel (15),
la surface de raccordement de boîtier fonctionnel (15) présentant au moins une deuxième ouverture (23) et au moins un élément d'engagement (34) agencé au niveau de la deuxième ouverture (23),
le module fonctionnel (3, 4, 5, 8, 10) présentant une structure de capuchon (37) avec un composant dur (38) et un composant souple (39) agencé sur le composant dur (38),
le composant dur (38) présentant un cadre (40) s'étendant autour de la deuxième ouverture (23) et au moins un logement d'enfichage (41) relié au cadre (40), le composant souple (39) de la structure de capuchon (37) entourant latéralement la deuxième ouverture (23),
**caractérisé**
**en ce que** la surface de raccordement de boîtier fonctionnel (15) présente un manchon d'étanchéité (35) s'étendant autour de la deuxième ouverture (23), une paroi de l'élément d'engagement (34) présentant un évidement (45), un bord délimitant l'évidement (45) de la paroi de l'élément d'engagement (34) formant une butée (47) sur un côté de l'évidement (45) détourné de la surface de raccordement de boîtier fonctionnel (15),
**en ce que** le composant souple (39) de la structure de capuchon (37) est agencé sur un côté du cadre (40) tourné vers la surface de raccordement de boîtier fonctionnel (15),
**en ce qu'**un crochet d'encliquetage (43) est agencé sur une paroi du logement d'enfichage (41), l'élément d'engagement (34) étant inséré dans le logement d'enfichage (41) de telle sorte que le composant souple (39) s'applique contre une paroi extérieure du manchon d'étanchéité (35) et le crochet d'encliquetage (43) s'engage dans l'évidement (45),
le composant souple (39) de la structure de capuchon (37) agençant le composant dur (38) de la structure de capuchon (37) sur la surface de raccordement de boîtier fonctionnel (15) de telle sorte que le crochet d'encliquetage (43) du logement d'enfichage (41) bute contre la butée (47) de l'élément d'engagement (34),
**en ce que** le module fonctionnel (3, 4, 5, 8, 10) peut être placé sur le module de base (2) de telle sorte que, lorsque le dispositif de liaison (16) est ouvert, la structure de capuchon (37) s'engage dans la première ouverture (22) dans la surface de raccordement de boîtier de base (13) de telle sorte que le cadre (40) du composant dur (38) de la structure de capuchon (37) repose sur la saillie (49) dans la surface de raccordement de boîtier de base (13) et la paroi extérieure du manchon d'étanchéité (35) s'appuie contre le composant souple (39) de la structure de capuchon (37) de telle sorte que la surface de raccordement de boîtier fonctionnel (15) est espacée de la surface de raccordement de boîtier de base (13) et, lorsque le dispositif de liaison (16) est fermé, la surface de raccordement de boîtier fonctionnel (15) est pressée contre la surface de raccordement de boîtier de base (13) de telle sorte
que le composant souple (39) de la structure de capuchon (37) est pressé radialement dans les zones entre la saillie (49) dans la surface de raccordement de boîtier de base (13) et la paroi extérieure du manchon d'étanchéité (35) et l'élément d'engagement (34) de la surface de raccordement de boîtier fonctionnel (15) est inséré dans le logement d'enfichage (41) du composant dur (38) de la structure de capuchon (37) de telle sorte que le crochet d'encliquetage (43) du logement d'enfichage (41) est espacé de la butée (47) de l'élément d'engagement (34).

2. Module fonctionnel (3, 4, 5, 8, 10) selon la revendication 1,
la surface de raccordement de boîtier fonctionnel (15) présentant au moins un autre élément d'engagement (36) agencé à l'opposé de la deuxième ouverture (23) et de l'élément d'engagement (34),
une paroi de l'autre élément d'engagement (36) présentant un autre évidement (46),
un autre bord délimitant l'autre évidement (46) de la paroi de l'autre élément d'engagement (36) formant une autre butée (48) sur un côté de l'autre évidement (46) détourné de la surface de raccordement de boîtier fonctionnel (15), le composant dur (38) présentant au moins un autre logement d'enfichage (42) relié au cadre (40),
un autre crochet d'encliquetage (44) étant agencé sur une paroi de l'autre logement d'enfichage (42),
l'autre élément d'engagement (36) étant inséré dans l'autre logement d'enfichage (42) de telle sorte que le composant souple (39) s'applique contre une paroi extérieure du manchon d'étanchéité (35) et l'autre crochet d'encliquetage (44) s'engage dans l'autre évidement (46), le composant souple (39) de la structure de capuchon (37) agençant le composant dur (38) de la structure de capuchon (37) contre la surface de raccordement de boîtier fonctionnel (15) de telle sorte que l'autre crochet d'encliquetage (44) de l'autre logement d'enfichage (42) bute contre l'autre butée (48) de l'autre élément d'engagement (36),
lorsque le dispositif de liaison (16) est fermé, l'autre élément d'engagement (36) de la surface de raccordement de boîtier fonctionnel (15) étant inséré dans l'autre logement d'enfichage (42) du composant dur (38) de la structure de capuchon (37) de telle sorte que l'autre crochet d'encliquetage (44) de l'autre logement d'enfichage (42) est espacé de l'autre butée (48) de l'autre élément d'engagement (36).

3. Module fonctionnel (3, 4, 5, 8, 10) selon la revendication 1 ou 2,
le manchon d'étanchéité (35) étant réalisé de manière à se rétrécir au moins par sections à partir de la surface de raccordement de boîtier fonctionnel (15),
le composant souple (39) de la structure de capuchon (37) s'appliquant dans la zone de la section qui se rétrécie contre la paroi extérieure du manchon d'étanchéité (35).

4. Module fonctionnel (3, 4, 5, 8, 10) selon l'une des revendications précédentes,
le manchon d'étanchéité (35) étant relié à l'élément d'engagement (34, 36) et étant formé dans la zone de l'élément d'engagement (34, 36) par celui-ci ou entourant latéralement l'élément d'engagement (34, 36).

5. Module fonctionnel (3, 10) selon l'une des revendications précédentes,
un composant souple supplémentaire (50) étant agencé entre la surface de raccordement de boîtier fonctionnel (15) et les parois latérales (25) du boîtier fonctionnel (14),
lorsque le module fonctionnel (3, 10) est placé sur le module de base (2), lorsque le dispositif de liaison (16) est ouvert, le composant souple supplémentaire (50) étant agencé sur la surface de raccordement de boîtier de base (13) et, lorsque le dispositif de liaison (16) est fermé, il étant pressé contre la surface de raccordement de boîtier de base (13).

6. Module fonctionnel (3, 10) selon la revendication 5,
les parois latérales (25) du boîtier fonctionnel (14) présentant une autre saillie (52) sur un côté intérieur du boîtier fonctionnel (14),
lorsque le module fonctionnel (3, 10) est placé sur le module de base (2), lorsque le dispositif de liaison (16) est ouvert, le composant souple supplémentaire (50) s'appliquant contre l'autre saillie (52) et, lorsque le dispositif de liaison (16) est fermé, il étant pressé contre l'autre saillie (52).

7. Module fonctionnel (3, 10) selon la revendication 5 ou 6,
la surface de raccordement de boîtier fonctionnel (15) présentant une saillie supplémentaire (54) dépassant en direction des parois latérales (25) du boîtier fonctionnel (14),
la saillie supplémentaire (54) étant intégrée dans le composant souple supplémentaire (50).

8. Module fonctionnel (3, 4, 5, 8) selon l'une des revendications 1 à 4,
la surface de raccordement de boîtier fonctionnel (15) étant reliée de manière rigide aux parois latérales (25) du boîtier fonctionnel (14),
un autre composant souple (31) étant agencé dans une rainure (32) réalisée sur la surface de raccordement de boîtier fonctionnel (15),
lorsque le module fonctionnel (3, 4, 5, 8) est placé sur le module de base (2), lorsque le dispositif de liaison (16) est ouvert, l'autre composant souple (31) étant agencé sur la surface de raccordement de boîtier de base (13) et, lorsque le dispositif de liaison (16) est fermé, il étant pressé contre la surface de raccordement de boîtier de base (13).

9. Plateforme d'automatisation (1)
avec un module de base (2), au moins un module fonctionnel (3, 4, 5, 8, 10) selon l'une des revendications précédentes, et au moins un dispositif de liaison (16) pour relier le module de base (2) et le module fonctionnel (3, 4, 5, 8, 10),
le module de base (2) présentant un boîtier de base (12) avec une surface de raccordement de boîtier de base (13), la surface de raccordement de boîtier de base (13) présentant au moins une première ouverture (22),
une saillie (49) s'étendant autour de la première ouverture (22) étant réalisée dans la surface de raccordement de boîtier de base (13),
le module fonctionnel (3, 4, 5, 8, 10) étant placé sur le module de base (2) et, lorsque le dispositif de liaison (16) est ouvert, le composant souple (39) de la structure de capuchon (37) agençant le composant dur (38) de la structure de capuchon (37) sur la surface de raccordement de boîtier fonctionnel (15) de telle sorte que le crochet d'encliquetage (43) du logement d'enfichage (41) bute contre la butée (47) de l'élément d'engagement (34), la structure de capuchon (37) s'engageant dans la première ouverture (22) dans la surface de raccordement de boîtier de base (13) de telle sorte que le cadre (40) du composant dur (38) de la structure de capuchon (37) repose sur la saillie (49) dans la surface de raccordement de boîtier de base (13) et la paroi extérieure du manchon d'étanchéité (35) s'appuyant contre le composant souple (39) de la structure de capuchon (37) de telle sorte que la surface de raccordement de boîtier fonctionnel (15) est espacée de la surface de raccordement de boîtier de base (13) et, lorsque le dispositif de liaison (16) est fermé, la surface de raccordement de boîtier fonctionnel (15) étant pressée contre la surface de raccordement de boîtier de base (13) de telle sorte que le composant souple (39) de la structure de capuchon (37) est pressé radialement dans les zones entre la saillie (49) dans la surface de raccordement de boîtier de base (13) et la paroi extérieure du manchon d'étanchéité (35), et l'élément d'engagement (34) de la surface de raccordement de boîtier fonctionnel (15) étant inséré dans le logement d'enfichage (41) du composant dur (38) de la structure de capuchon (37) de telle sorte que le crochet d'encliquetage (43) du logement d'enfichage (41) est espacé de la butée (47) de l'élément d'engagement (34).

10. Plateforme d'automatisation (1) selon la revendication 9, dans la mesure où elle dépend de la revendication 2,
le module fonctionnel (3, 4, 5, 8, 10) étant placé sur le module de base (2) et, lorsque le dispositif de liaison (16) est ouvert, le composant souple (39) de la structure de capuchon (37) agençant le composant dur (38) de la structure de capuchon (37) sur la surface de raccordement de boîtier fonctionnel (15) de telle sorte que l'autre crochet d'encliquetage (44) de l'autre logement d'enfichage (42) bute contre l'autre butée (48) de l'autre élément d'engagement (36),
lorsque le dispositif de liaison (16) est fermé, l'autre élément d'engagement (36) de la surface de raccordement de boîtier fonctionnel (15) étant inséré dans l'autre logement d'enfichage (42) du composant dur (38) de la structure de capuchon (37) de telle sorte que l'autre crochet d'encliquetage (44) de l'autre logement d'enfichage (42) est espacé de l'autre butée (48) de l'autre élément d'engagement (36).

11. Plateforme d'automatisation (1) selon la revendication 9, dans la mesure où elle dépend de la revendication 5,
un composant souple supplémentaire (50) étant agencé entre la surface de raccordement de boîtier fonctionnel (15) et les parois latérales (25) du boîtier fonctionnel (14),
lorsque le module fonctionnel (3, 10) est placé sur le module de base (2), lorsque le dispositif de liaison (16) est ouvert, le composant souple supplémentaire (50) étant agencé sur la surface de raccordement de boîtier de base (13) et, lorsque le dispositif de liaison (16) est fermé, il étant pressé contre la surface de raccordement de boîtier de base (13).

12. Plateforme d'automatisation (1) selon la revendication 9, dans la mesure où elle dépend de la revendication 6,
lorsque le module fonctionnel (3, 10) est placé sur le module de base (2), lorsque le dispositif de liaison (16) est ouvert, le composant souple supplémentaire (50) s'appliquant contre l'autre saillie (52) et, lorsque le dispositif de liaison (16) est fermé, il étant pressé contre l'autre saillie (52).

13. Plateforme d'automatisation (1) selon la revendication 9, dans la mesure où elle dépend de la revendication 7,
le module fonctionnel (3, 10) étant placé sur le module de base (2), et, lorsque le dispositif de liaison (16) est ouvert, le composant souple supplémentaire (50) s'appliquant contre la saillie supplémentaire (54) et, lorsque le dispositif de liaison (16) est fermé, il étant pressé contre la saillie supplémentaire (54).

14. Plateforme d'automatisation (1) selon la revendication 9, dans la mesure où elle dépend des revendications 1 à 4,
le module fonctionnel (3, 4, 5, 8) étant placé sur le module de base (2), et, lorsque le dispositif de liaison (16) est ouvert, l'autre composant souple (31) étant agencé sur la surface de raccordement de boîtier de base (13) et, lorsque le dispositif de liaison (16) est fermé, il étant pressé contre la surface de raccordement de boîtier de base (13).

15. Procédé pour monter une plateforme d'automatisation (1) selon l'une des revendications 9 à 14, comprenant les étapes de procédé suivantes :
- la mise en place du module fonctionnel (3, 4, 5, 8, 10) sur le module de base (2) de telle sorte que la structure de capuchon (37) s'engage dans la première ouverture (22) dans la surface de raccordement de boîtier de base (13) de telle sorte que le cadre (40) du composant dur (38) de la structure de capuchon (37) repose sur la saillie (49) dans la surface de raccordement de boîtier de base (13) et les parois extérieures du manchon d'étanchéité (35) s'appuient sur le composant souple (39) de la structure de capuchon (37) de telle sorte que la surface de raccordement de boîtier fonctionnel (15) soit espacée de la surface de raccordement de boîtier de base (13),
- la fermeture du dispositif de liaison (16), moyennant quoi la surface de raccordement de boîtier fonctionnel (15) est pressée contre la surface de raccordement de boîtier de base (13) de telle sorte que le composant souple (39) de la structure de capuchon (37) est pressé radialement dans les zones entre la saillie (49) dans la surface de raccordement de boîtier de base (13) et la paroi extérieure du manchon d'étanchéité (35) et l'élément d'engagement (34) de la surface de raccordement de boîtier fonctionnel (15) est inséré dans le logement d'enfichage (41) du composant dur (38) de la structure de capuchon (27) de telle sorte que le crochet d'encliquetage (43) du logement d'enfichage (41) est espacé de la butée (47) de l'élément d'engagement (34), et, en option, l'étape de procédé supplémentaire suivante :
- le détachement du dispositif de liaison (16), moyennant quoi le composant souple (39) appuie contre la paroi extérieure du manchon d'étanchéité (35) de telle sorte que la surface de raccordement de boîtier fonctionnel (15) est espacée de la surface de raccordement de boîtier de base (13) et le crochet d'encliquetage (43) s'applique contre la butée (47) de l'élément d'engagement (34).
